(19) **Europäisches Patentamt European Patent Office Office européen des brevets**

(11) **EP 4 734 379 A1**

(12) **EUROPEAN PATENT APPLICATION**
published in accordance with Art. 153(4) EPC

(43) Date of publication:
29.04.2026 Bulletin 2026/18

(21) Application number: 24836170.1

(22) Date of filing: 08.05.2024

(51) International Patent Classification (IPC):
*H04B 1/04* (2006.01)     *H04B 1/62* (2006.01)
*H03F 1/32* (2006.01)

(52) Cooperative Patent Classification (CPC):
H03F 1/32; H04B 1/04; H04B 1/62

(86) International application number:
PCT/KR2024/006191

(87) International publication number:
WO 2025/009721 (09.01.2025 Gazette 2025/02)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 06.07.2023  KR 20230087983
10.07.2023  KR 20230089420

(71) Applicant: Samsung Electronics Co., Ltd.
Suwon-si, Gyeonggi-do 16677 (KR)

(72) Inventors:
• LEE, Seonghyeon
Suwon-si, Gyeonggi-do 16677 (KR)
• KU, Jungwoo
Suwon-si, Gyeonggi-do 16677 (KR)
• KOO, Hyungmo
Suwon-si, Gyeonggi-do 16677 (KR)
• KIM, Jaebum
Suwon-si, Gyeonggi-do 16677 (KR)
• PARK, Gyudong
Suwon-si, Gyeonggi-do 16677 (KR)
• WOO, Youngyoon
Suwon-si, Gyeonggi-do 16677 (KR)

(74) Representative: Gulde & Partner
Patent- und Rechtsanwaltskanzlei mbB
Berliner Freiheit 2
10785 Berlin (DE)

(54) **ELECTRONIC DEVICE AND METHOD FOR DIGITAL PREDISTORTION IN WIRELESS COMMUNICATION SYSTEM**

(57) This electronic device may comprise: a memory for storing instructions; a transmission antenna; a power amplifier, a digital predistortion (DPD) circuit including a first DPD path and a second DPD path; and at least one processor. When executed by the at least one processor, the instructions can cause the electronic device to: predistort, on the basis of the first DPD path, a first digital signal having a first sampling rate; transmit a first output signal generated on the basis of the power amplifier from the predistorted first digital signal; provide, to the DPD circuit, on the basis of a correlation value for the first digital signal and the first output signal, a control signal for activating the second DPD path; predistort, on the basis of the second DPD path, a second digital signal having a second sampling rate; and transmit a second output signal generated on the basis of the power amplifier from the predistorted second digital signal.

FIG. 5

**Description**

[TECHNICAL FIELD]

The present disclosure relates to a wireless communication system. More specifically, the present disclosure relates to an electronic device and a method for digital predistortion in a wireless communication system.

[BACKGROUND ART]

In a wireless communication system, a digitally modulated signal is amplified through a (radio frequency) RF power amplifier. For distortion-free transmission of signals, a high linear characteristic of the power amplifier is required. In order to provide high linearity of the power amplifier, digital predistortion (DPD) for changing an input signal such that an output of the power amplifier is close to an ideal state is used.

[DISCLOSURE]

[TECHNICAL SOLUTION]

In embodiments, an electronic device may comprise memory comprising one or more storage media storing instructions. The electronic device may comprise a transmission antenna. The electronic device may comprise a power amplifier connected with the transmission antenna. The electronic device may comprise a digital predistortion (DPD) circuit connected with the power amplifier and including a first DPD path and a second DPD path. The electronic device may comprise at least one processor including processing circuitry. The instructions, when executed individually or collectively by the at least one processor, may cause the electronic device to, based on the first DPD path, perform predistortion with respect to a first digital signal having a first sampling rate. The instructions, when executed individually or collectively by the at least one processor, may cause the electronic device to, transmit, via the transmission antenna, a first output signal generated from the predistorted first digital signal based on the power amplifier. The instructions, when executed individually or collectively by the at least one processor, may cause the electronic device to, based on a correlation value between the first digital signal and the first output signal, provide, to the DPD circuit, a control signal for activating the second DPD path among the first DPD path and the second DPD path. The instructions, when executed individually or collectively by the at least one processor, may cause the electronic device to, perform predistortion with respect to a second digital signal subsequent to the first digital signal having a second sampling rate decreased by an integer-factor of the first sampling rate based on the second DPD path. The instructions, when executed individually or collectively by the at least one processor, may cause the electronic device to, transmit, via the transmission antenna, a second output signal generated from the predistorted second digital signal based on the power amplifier.
In embodiments, a method performed by an electronic device may comprise, based on a first digital predistortion (DPD) path of a DPD circuit included in the electronic device, performing predistortion with respect to a first digital signal having a first sampling rate. The method may comprise transmitting, a first output signal generated from the predistorted first digital signal based on the power amplifier. The method may comprise, based on a correlation value between the first digital signal and the first output signal, providing, to the DPD circuit, a control signal for activating a second DPD path among the first DPD path and the second DPD path of the DPD circuit, the correlation value equal or greater than a reference value. The method may comprise, performing predistortion with respect to a second digital signal subsequent to the first digital signal having a second sampling rate decreased by an integer-factor of the first sampling rate based on the second DPD path. The method may comprise, transmitting, a second output signal generated from the predistorted second digital signal based on the power amplifier.
In embodiments, an electronic device may comprise a transmission antenna. The electronic device may comprise a power amplifier connected with the transmission antenna. The electronic device may comprise a digital predistortion (DPD) circuit connected with the power amplifier. The DPD circuit may include a switch for selecting a first DPD path or a second DPD path, a down sampler for decreasing a sampling rate of a digital signal and an up sampler for increasing the sampling rate, a DPD actuator generating a signal on which predistortion is performed from the digital signal for a linearity of the power amplifier, and a delay block adjusting a processing delay between the first DPD path and the second DPD path. The first DPD path may include the DPD actuator and the delay block. The second DPD path may include the DPD actuator, the up sampler, and the down sampler.

[DESCRIPTION OF THE DRAWINGS]

FIG. 1 illustrates an example of a wireless communication system according to embodiments.

FIG. 2 illustrates an example of network entities according to a distributed arrangement according to embodiments.

FIG. 3A illustrates an example of a functional configuration of a digital unit (DU) according to embodiments.

FIG. 3B illustrates an example of a functional configuration of a radio unit (RU) according to embodiments.

FIG. 4A is an exemplary diagram for explaining a principle of digital predistortion (DPD) according to embodiments.

FIG. 4B illustrates an example of a DPD circuit according to embodiments.

FIG. 5 illustrates an example of a DPD circuit including a plurality of DPD paths according to embodiments.

FIG. 6 illustrates an example of a graph indicating correlation values for samples according to embodiments.

FIGS. 7A and 7B illustrate examples of graphs representing performance of a DPD circuit including a plurality of DPD paths according to embodiments.

FIG. 8 illustrates an example of an operation flow for a method of transmitting a signal based on a DPD circuit including a plurality of DPD paths according to embodiments.

[MODE FOR INVENTION]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

Terms referring to a signal (e.g., sample, data, message, signal, information, and signaling), terms referring to a resource (e.g., symbol, slot, subframe, radio frame, subcarrier, resource element (RE), resource block (RB), bandwidth part (BWP), and occasion), terms for operational a state (e.g., step, operation, and procedure), and terms referring to a component of a device, and the like, used in the following description are exemplified for convenience of explanation. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

The present disclosure describes embodiments by using terms used in some communication standards (e.g., 3rd Generation Partnership Project (3GPP)), but this is merely an example for description. Embodiments of the present disclosure may also be applied to other communication and broadcasting systems.

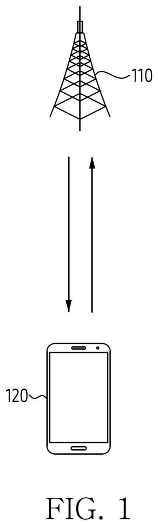

FIG. 1 illustrates an example of a wireless communication system.

Referring to FIG. 1, FIG. 1 illustrates a base station 110 and a terminal 120 as a portion of nodes that utilize a wireless channel in a wireless communication system. FIG. 1 illustrates only one base station, but a wireless communication system may further include another base station that is identical or similar to the base station 110.

The base station 110 is a network infrastructure that provides wireless access to the terminal 120. The base station 110 has coverage defined based on a distance at which a signal may be transmitted. In addition to 'base station', the base station 110 may be referred to as an 'access point (AP)', 'eNodeB (eNB)', '5th generation node', 'next generation nodeB (gNB)', 'wireless point', 'transmission/reception point (TRP)' or other terms having equivalent technical meanings.

The terminal 120, which is a device used by a user, performs communication with the base station 110 through a wireless channel. A link from the base station 110 to the terminal 120 is referred to as a downlink (DL), and a link from the terminal 120 to the base station 110 is referred to as an uplink (UL). In addition, although not illustrated in FIG. 1, the terminal 120 and another terminal may perform communication with each other through a wireless channel. At this time, a link (device-to-device link (D2D)) between the terminal 120 and the other terminal is referred to as a sidelink, and the sidelink may be used interchangeably with a PC5 interface. In some other embodiments, the terminal 120 may be operated without the user's involvement. According to an embodiment, the terminal 120, which is a device performing machine type communication (MTC), may not be carried by the user. Additionally, according to an embodiment, the terminal 120 may be a narrowband (NB)-internet of things (IoT) device.

In addition to 'terminal', the terminal 120 may also be referred to as 'user equipment (UE) ', 'customer premises equipment, (CPE) ', 'mobile station', 'subscriber station', 'remote terminal', 'wireless terminal', 'electronic device', 'user device', or other terms having equivalent technical meanings.

The base station 110 may perform beamforming with the terminal 120. The base station 110 and the terminal 120 may transmit and receive a wireless signal in a relatively low frequency band (e.g., frequency range 1 (FR 1) of NR). In addition, the base station 110 and the terminal 120 may transmit and receive a wireless signal in a relatively high frequency band (e.g., FR 2 (or FR 2-1, FR 2-2, FR 2-3) or FR 3), and a mmWave band (e.g., 28GHz, 30GHz, 38GHz, 60GHz). The base station 110 and the terminal 120 may perform beamforming to improve a channel gain. Herein, the beamforming may include transmission beamforming and reception beamforming. The base station 110 and the terminal 120 may provide directivity to a transmission signal or a reception signal. To this end, the base station 110 and the terminal 120 may select serving beams through a beam search or beam management procedure. After the serving beams are selected, subsequent communication may be performed through a resource in a QCL relationship with the resource transmitting the serving beams.

If large-scale characteristics of a channel carrying a symbol on a first antenna port may be inferred from a channel carrying a symbol on a second antenna port, the first antenna port and the second antenna port may be evaluated to be in the QCL relationship. For example, large-scale characteristics may include at least one of a delay spread, a Doppler spread, a Doppler shift, an average gain, an average delay, and a spatial receiver parameter.

Although FIG. 1 describes that both the base station 110 and the terminal 120 perform beamforming, the embodiments of the present disclosure are not necessarily limited thereto. In some embodiments, the terminal may or may not perform beamforming. In addition, the base station may or may not perform beamforming. That is, either only one of the base station and the terminal may perform beamforming, or neither the base station nor the terminal may perform beamforming.

In the present disclosure, a beam refers to a spatial flow of a signal in a wireless channel, and is formed by one or more antennas (or antenna elements), and this formation process may be referred to as beamforming. Beamforming may include at least one of analog beamforming or digital beamforming (e.g., precoding). A reference signal transmitted based on beamforming may include, for example, a demodulation-reference signal (DM-RS), a channel state information-reference signal (CSI-RS), a synchronization signal/physical broadcast channel (SS/PBCH), and a sounding reference signal (SRS). In addition, an IE such as CSI-RS resource or SRS-resource may be used as a configuration for each reference signal, and this configuration may include information associated with the beam. The information associated with the beam may mean whether a corresponding configuration (e.g., CSI-RS resource) uses the same spatial domain filter as another configuration (e.g., another CSI-RS resource within the same CSI-RS resource set) or a different spatial domain filter, or which reference signal it is quasi-co-located (QCL) with, and if so, what type it is (e.g., QCL type A, B, C, D).

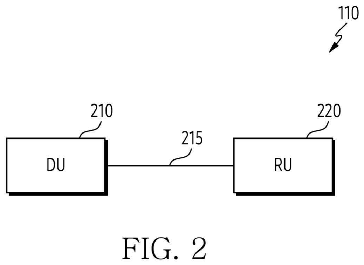

Conventionally, in a communication system with a relatively large cell radius of base station, each base station was installed to include a function of a digital processing unit (or distributed unit (DU)) and a radio frequency (RF) processing unit (or radio unit (RU)). However, as high frequency bands are used in 4th generation (4G) and/or subsequent communication systems (e.g., 5G) and the cell coverage of base stations becomes smaller, the number of base stations to cover a specific area has increased. The burden of installation cost for operators to install base stations has also increased. In order to minimize the installation cost of a base station, a structure in which the DU and RU of the base station are separated, one or more RUs are connected to one DU through a wired network, and one or more Rus geographically distributed to cover a specific area are deployed, has been proposed. Hereinafter, a deployment structure and expansion examples of a base station according to various embodiments of the present disclosure are described through FIGS. 2.

FIG. 2 illustrates an example of network entities according to a distributed arrangement.

For example, the network entities may include a digital unit (DU) 210 and a radio unit (RU) 220 (or a massive multiple input multiple output unit (MMU)). For example, the network entities may be connected through a fronthaul. The fronthaul refers to a connection between entities (e.g., the DU 210 and the RU 220) between a wireless LAN and a base station, unlike a backhaul between a base station and a core network. FIG. 2 illustrates an example of a fronthaul structure between one DU 210 and one RU 220, but this is merely for convenience of description and the present disclosure is not limited thereto. In other words, embodiments of the present disclosure may also be applied to a fronthaul structure between one DU and a plurality of RUs. For example, embodiments of the present disclosure may be applied to a fronthaul structure between one DU and two RUs. Also, embodiments of the present disclosure may be applied to a fronthaul structure between one DU and three RUs.

Referring to FIG. 2, the base station 110 may include a DU 210 and an RU 220. A fronthaul 215 between the DU 210 and the RU 220 may be operated via an Fx interface. For operation of the fronthaul 215, an interface such as an enhanced common public radio interface (eCPRI) or radio over ethernet (ROE) may be used.

As communication technology has been developed, mobile data traffic increased, and thus the bandwidth demand required in a fronthaul between a digital unit and a radio unit has increased significantly. In a deployment such as centralized/cloud radio access network (C-RAN), the DU may be implemented to perform functions for packet data convergence protocol (PDCP), radio link control (RLC), media access control (MAC), and physical (PHY), and the RU may be implemented to further perform functions for PHY layer in addition to a radio frequency (RF) function.

The DU 210 may be in charge of upper layer functions of a wireless network. For example, the DU 210 may perform functions of the MAC layer and a part of the PHY layer. Herein, a part of the PHY layer is a function performed at a higher level among the functions of the PHY layer, and may include, for example, channel encoding (or channel decoding), scrambling (or descrambling), modulation (or demodulation), and layer mapping (or layer demapping). According to an embodiment, if the DU 210 complies with an O-RAN standard, it may be referred to as an O-RAN DU (O-DU). The DU 210 may be replaced with and represented as a first network entity for a base station (e.g., gNB) in embodiments of the present disclosure, as needed.

The RU 220 may be in charge of lower layer functions of a wireless network. For example, the RU 220 may perform a part of the PHY layer, and a RF function. Herein, a part of the PHY layer is a function performed at performed at a relatively lower level than the DU 210 among the functions of the PHY layer, and may include, for example, iFFT conversion (or FFT conversion), cyclic prefix (CP) insertion (or CP removal), and digital beamforming. The RU 220 may be referred to as access unit (AU), access point (AP), transmission/reception point (TRP), remote radio head (RRH), radio unit (RU), or other terms having equivalent technical meanings. According to an embodiment, if the RU 220 complies with the O-RAN standard, it may be referred to as an O-RAN RU (O-RU). The RU 220 may be replaced with and represented as a second network entity for a base station (e.g., gNB) in embodiments of the present disclosure, as needed.

Although FIG. 2 describes that the base station 110 includes the DU 210 and the RU 220, the embodiments of the present disclosure are not limited thereto. The base station according to the embodiments may be implemented in a distributed deployment according to a centralized unit (CU) configured to perform functions of upper layers (e.g., packet data convergence protocol (PDCP), radio resource control (RRC)) of an access network and a distributed unit (DU) configured to perform functions of lower layers. As an example, the digital unit (DU) 210 may be implemented by being split into a centralized unit (CU) and a distributed unit (DU). Between a core (e.g., 5G core (5GC) or next generation core (NGC)) network and a radio access network (RAN), the base station may be implemented in a structure in which a centralized unit (CU), a distributed unit (DU), and a radio unit (RU) are arranged in order. An interface between the centralized unit (CU) and the distributed unit (DU) may be referred to as an F1 interface.

A centralized unit (CU) may be in charge of functions of a higher layer than the distributed unit (DU), by being connected to one or more distributed units (Dus). For example, the CU may be in charge of radio resource control (RRC) and a function of a packet data convergence protocol (PDCP) layer, and the DU and the RU may be in charge of functions of lower layers. The DU may perform radio link control (RLC), media access control (MAC), and some functions (high PHY) of PHY layer, and the RU may perform remaining functions (low PHY) of the PHY layer. In addition, as an example, a digital unit (DU) may be included in a distributed unit (DU) according to the implementation of distributed deployment of the base station. Hereinafter, unless otherwise defined, it is described as operations of the digital unit (DU) and the RU, but various embodiments of the present disclosure may be applied to both of a base station arrangement including the CU or an arrangement where the DU is directly connected to a core network (i.e., the CU and the DU are integrated into a base station (e.g., NG-RAN node) which is a single entity).

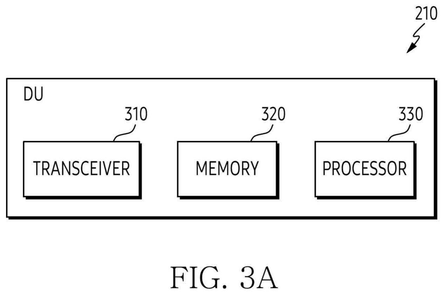

FIG. 3A illustrates an example of a functional configuration of a digital unit (DU).

A configuration exemplified in FIG. 3A, which is as a part of a base station, may be understood as a configuration of the DU 210 of FIG. 2. Hereinafter, the terms '...unit' and '...er' used below refer to a unit processing at least one function or operation, which may be implemented by hardware or software, or a combination of hardware and software.

Referring to FIG. 3A, a DU 210 includes a transceiver 310, memory 320, and a processor 330.

The transceiver 310 may perform functions for transmitting and receiving a signal in a wired communication environment. The transceiver 310 may include a wired interface for controlling a direct device-to-device connection through a transmission medium (e.g., copper wire, optical fiber). For example, the transceiver 310 may transmit an electrical signal to another device through a copper wire or perform conversion between an electrical signal and an optical signal. The DU 210 may communicate with a radio unit (RU) through the transceiver 310. The DU 210 may be connected to a core network or a CU of a distributed deployment through the transceiver 310.

The transceiver 310 may also perform functions for transmitting and receiving a signal in a wireless communication environment. For example, the transceiver 310 may perform a conversion function between a baseband signal and a bit string according to a physical layer specification of a system. For example, upon transmitting data, the transceiver 310 generates complex-valued symbols by encoding and modulating a transmission bit string. In addition, upon receiving data, the transceiver 310 restores a received bit string by demodulating and decoding a baseband signal. In addition, the transceiver 310 may include a plurality of transmission/reception paths. In addition, according to an embodiment, the transceiver 310 may be connected to a core network or to other nodes (e.g., integrated access backhaul (IAB)).

The transceiver 310 may transmit and receive a signal. For example, the transceiver 310 may transmit a management plane (M-plane) message. For example, the transceiver 310 may transmit a synchronization plane (S-plane) message. For example, the transceiver 310 may transmit a control plane (C-plane) message. For example, the transceiver 310 may transmit a user plane (U-plane) message. For example, the transceiver 310 may receive the U-plane message. Although only the transceiver 310 is illustrated in FIG. 3A, the DU 210 may include two or more transceivers according to another implementation.

The transceiver 310 transmits and receives a signal as described above. Accordingly, all or some of the transceiver 310 may be referred to as a 'communication unit', a 'transmission unit', a 'reception unit', or a 'transmission/reception unit'. In addition, in the following description, transmission and reception performed through a wireless channel are used to the meaning including that the processing as described above is performed by the transceiver 310.

Although not illustrated in FIG. 3A, the transceiver 310 may further include a backhaul transceiver for connection with a core network or another base station. The backhaul transceiver provides an interface for performing communication with other nodes in the network. In other words, the backhaul transceiver converts a bit string transmitted from a base station to another node, such as another access node, another base station, an upper node, and a core network into a physical signal, and converts a physical signal received from another node into a bit string.

The memory 320 stores a basic program, an application program, and data such as configuration information for an operation of the DU 210. The memory 320 may be referred to as a storage unit. The memory 320 may be configured with a volatile memory, a nonvolatile memory, or a combination of the volatile memory and the nonvolatile memory. In addition, the memory 320 provides stored data according to a request from the processor 330.

The processor 330 controls overall operations of the DU 210. The processor 380 may be referred to as a control unit. For example, the processor 330 transmits and receives a signal through the transceiver 310 (or through a backhaul communication unit). In addition, the processor 330 writes and reads data in the memory 320. In addition, the processor 330 may perform functions of a protocol stack required in a communication standard. Although only the processor 330 is illustrated in FIG. 3A, the DU 210 may include two or more processors according to another implementation.

For example, the processor 330 may include various processing circuitry and/or a plurality of processors. For example, the term "processor" as used in this document including the claims may include various processing circuitry including at least one processor, and one or more of the at least one processor may be configured to individually and/or collectively perform various functions described below in a distributed manner. As used herein, when "processor", "at least one processor", and "one or more processors" are described as being configured to perform various functions, these terms are not limited thereto and encompass situations in which one processor performs some of the cited functions and other processor(s) perform other ones of the cited functions, and also situations in which one processor performs all of the cited functions. Additionally, the at least one processor may include a combination of processors that perform the various listed/disclosed functions, for example, in a distributed manner. The at least one processor may execute program instructions to achieve or perform various functions.

A configuration of the DU 210 illustrated in FIG. 3A is only an example, and an example of the DU performing the embodiments of the present disclosure is not limited to the configuration illustrated in FIG. 3A. In some embodiment, some configurations may be added, deleted, or changed.

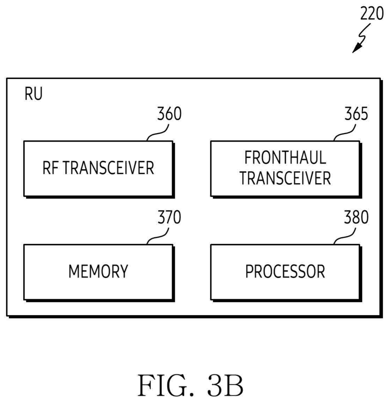

FIG. 3B illustrates an example of a functional configuration of a radio unit (RU).

A configuration exemplified in FIG. 3B, which is as a part of a base station, may be understood as a configuration of the RU 220 of FIG. 2. Hereinafter, the terms '...unit' and '...er' used below refer to a unit processing at least one function or operation, which may be implemented by hardware or software, or a combination of hardware and software.

Referring to FIG. 3B, the RU 220 includes an RF transceiver 360, a fronthaul transceiver 365, memory 370, and a processor 380.

The RF transceiver 360 performs functions for transmitting and receiving a signal through a wireless channel. For example, the RF transceiver 360 up-converts a baseband signal into an RF band signal and then transmits it through an antenna, and down-converts an RF band signal received through the antenna into a baseband signal. For example, the RF transceiver 360 may include a transmission filter, a reception filter, an amplifier, a mixer, an oscillator, a DAC, an ADC.

The RF transceiver 360 may include a plurality of transmission/reception paths. Furthermore, the RF transceiver 360 may include an antenna unit. The RF transceiver 360 may include at least one antenna array composed of a plurality of antenna elements. In terms of hardware, the RF transceiver 360 may be composed of a digital circuit and an analog circuit (e.g., a radio frequency integrated circuit (RFIC)). Herein, the digital circuit and the analog circuit may be implemented as a single package. In addition, the RF transceiver 360 may include a plurality of RF chains. The RF transceiver 360 may perform beamforming. In order to provide directivity to a signal to be transmitted and received according to the setting of the processor 380, the RF transceiver 360 may apply beamforming weights to the signal. According to an embodiment, the RF transceiver 360 may include a radio frequency (RF) block (or RF unit).

According to an embodiment, the RF transceiver 360 may transmit and receive a signal on a radio access network. For example, the RF transceiver 360 may transmit a downlink signal. The downlink signal may include a synchronization signal (SS), a reference signal (RS) (e.g., cell-specific reference signal (CRS), demodulation (DM)-RS), system information (e.g., MIB, SIB, remaining system information (RMSI), other system information (OSI)), configuration message, control information or downlink data. In addition, for example, the RF transceiver 360 may receive an uplink signal. The uplink signal may include a random access-related signal (e.g., random access preamble (RAP)) (or message 1 (Msg1), message 3 (Msg3)), a reference signal (e.g., sounding reference signal (SRS), DM-RS), or a power headroom report (PHR). Although only the RF transceiver 360 is illustrated in FIG. 3B, the RU 220 may include two or more RF transceivers according to another implementation.

The fronthaul transceiver 365 may transmit and receive a signal. According to an embodiment, the fronthaul transceiver 365 may transmit and receive a signal on a fronthaul interface. For example, the fronthaul transceiver 365 may receive a management plane (M-plane) message. For example, the fronthaul transceiver 365 may receive a synchronization plane (S-plane) message. For example, the fronthaul transceiver 365 may receive a control plane (C-plane) message. For example, the fronthaul transceiver 365 may transmit a user plane (U-plane) message. For example, the fronthaul transceiver 365 may receive a U-plane message. Although only the fronthaul transceiver 365 is illustrated in FIG. 3B, the RU 220 may include two or more fronthaul transceivers according to another implementation.

As described above, the RF transceiver 360 and the fronthaul transceiver 365 transmit and receive a signal. Accordingly, all or some of the RF transceiver 360 and the fronthaul transceiver 365 may be referred to as a 'communication unit', a 'transmission unit', a 'reception unit', or a 'transmission/reception unit'. In addition, in the following description, transmission and reception performed through a wireless channel are used to the meaning including that the processing as described above is performed by the RF transceiver 360. In the following description, transmission and reception performed through a wireless channel are used to the meaning including that the processing as described above is performed by the RF transceiver 360.

The memory 370 stores a basic program, an application program, and data such as configuration information for an operation of the RU 220. The memory 370 may be referred to as a storage unit. The memory 370 may be configured with a volatile memory, a nonvolatile memory, or a combination of the volatile memory and the nonvolatile memory. In addition, the memory 370 provides stored data according to a request from the processor 380. According to an embodiment, the memory 370 may include a memory for a condition, a command, or a setting value related to an SRS transmission scheme.

The processor 380 controls overall operations of the RU 220. The processor 380 may be referred to as a control unit. For example, the processor 380 transmits and receives a signal through the RF transceiver 360 or the fronthaul transceiver 365. In addition, the processor 380 writes and reads data in the memory 370. In addition, the processor 380 may perform functions of a protocol stack required by a communication standard. Although only the processor 380 is illustrated in FIG. 3B, the RU 220 may include two or more processors according to another implementation. The processor 380, which is an instruction set or code stored in the memory 370, may be an instruction/code at least temporarily resided in the processor 380 or a storage space storing instruction/code, or part of circuitry constituting the processor 380. In addition, the processor 380 may include various modules for performing communication. The processor 380 may control the RU 220 to perform operations according to embodiments to be described later.

For example, the processor 380 may include various processing circuitry and/or a plurality of processors. For example, the term "processor" as used in this document including the claims may include various processing circuitry including at least one processor, and one or more of the at least one processor may be configured to individually and/or collectively perform various functions described below in a distributed manner. As used herein, when "processor", "at least one processor", and "one or more processors" are described as being configured to perform various functions, these terms are not limited thereto and encompass situations in which one processor performs some of the cited functions and other processor(s) perform other ones of the cited functions, and also situations in which one processor performs all of the cited functions. Additionally, the at least one processor may include a combination of processors that perform the various listed/disclosed functions, for example, in a distributed manner. The at least one processor may execute program instructions to achieve or perform various functions.

A configuration of the RU 220 illustrated in FIG. 3B is only an example, and an example of the RU performing the embodiments of the present disclosure is not limited to the configuration illustrated in FIG. 3B. In some embodiment, some configurations may be added, deleted, or changed.

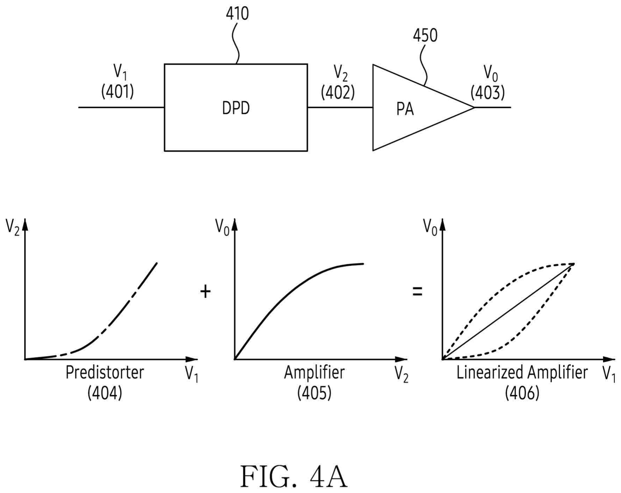

FIG. 4A is an exemplary diagram for explaining a principle of digital predistortion (DPD) according to embodiments.

The DPD may indicate a method for improving nonlinearity of a power amplifier. For example, predistortion may be performed in a DPD circuit 410. For example, the predistortion may include digital predistortion. For example, the DPD circuit 410 may be referred to as a digital predistorter, a digital predistortion circuit (DPD circuit), a digital predistortion module (DPD module), or a DPD model. Based on a comparison between an input signal and an output signal of a power amplifier (PA) 450, the DPD circuit 410 may compensate for a distortion component according to a nonlinear characteristic of the power amplifier 450. As a distorted input modulation signal is inputted to the power amplifier 450 through the DPD circuit 410, a finally modulated signal may be linearly amplified.

Referring to FIG. 4A, a DPD circuit 410 may output a DPD output signal 402 based on an input signal 401. The input signal 401 may be predistorted to the DPD output signal 402 through the DPD circuit 410. The power amplifier 450 may output an amplifier output signal 403 based on the DPD output signal 402. The DPD output signal 402 may be inputted to the power amplifier 450. According to a nonlinear characteristic of the power amplifier 450, the DPD output signal 402 is distorted. Due to distortion caused by the power amplifier 450, the amplifier output signal 403 is output. Although not illustrated in FIG. 4A, analog conversion may be performed on the DPD output signal 402 through a DAC, and upconversion may be performed on the DPD output signal 402 through a mixer. In other words, the input signal 401 (or a DPD input signal) and the DPD output signal 402 before analog conversion is performed may be digital signals. Also, the amplifier output signal 403 may be an analog signal.

A graph 404 represents a relationship between a magnitude of the input signal 401 and a magnitude of the DPD output signal 402. A graph 405 represents a relationship between a magnitude of the DPD output signal 402 and a magnitude of the amplifier output signal 403. A graph 406 represents a relationship between a magnitude of the input signal 401 and a magnitude of the amplifier output signal 403. Referring to the graph 406, through predistortion of the DPD circuit 410, an output (e.g., the amplifier output signal 403) relative to an input (e.g., the input signal 401) may be linear.

The power amplifier 450 may include a transistor. The transistor generates a harmonic component. Due to nonlinearity of a low-frequency second harmonic component corresponding to a bandwidth (f2-f1) (wherein f2 is a highest frequency and f1 is a lowest frequency), a memory effect occurs. As the low-frequency second harmonic component increases, impedance cancellation is not easy. Accordingly, as a signal bandwidth increases, the power amplifier 450 exhibits a memory effect. In a case that a modulation signal of a wireless communication system is used as a wide bandwidth signal, distortion components of the power amplifier 450 may include not only distortion components due to nonlinear characteristics but also distortion components due to a memory effect. The memory effect means that a signal nonlinearly generated in the past in time affects current nonlinearity. That is, the power amplifier 450 is a nonlinear system using memory.

The memory effect may be attributed to active devices or thermal constants of components of a biasing network having frequency-dependent behavior. As described above, distortion components due to a memory effect increase in proportion to a bandwidth of a signal. A DPD circuit 410 for compensating for nonlinear distortion components of the power amplifier 450 and distortion components due to a memory effect (memory compensated DPD) is required.

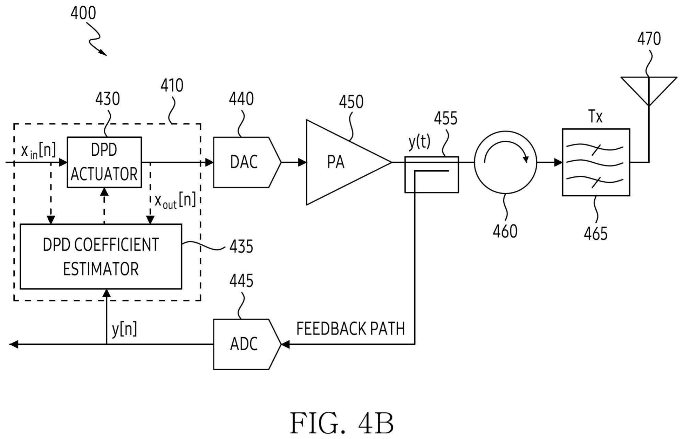

FIG. 4B illustrates an example of a DPD circuit according to embodiments.

FIG. 4B illustrates an example of an electronic device 400 including a DPD circuit 410. For example, the electronic device 400 may include the RU 220 of FIG. 2. However, embodiments of the present disclosure are not limited thereto. For example, at least a portion of the electronic device 400 may be implemented in the base station 110 of FIG. 1 or the DU 210 of FIG. 2.

Referring to FIG. 4B, the electronic device 400 may include a plurality of components for transmitting a signal. For example, the electronic device 400 may include a DPD circuit 410, a digital to analog converter (DAC) 440, an analog to digital converter (ADC) 445, a power amplifier 450, a coupler 455, an isolator 460, a filter 465, and a transmission antenna 470. For example, at least a portion of the plurality of components may be included in a transmission path. The transmission path may indicate a path for the electronic device 400 to radiate a transmission signal to an outside. For example, the transmission signal may be referred to as a signal radiated through the transmission antenna.

For example, the DPD circuit 410 may represent a circuit for performing predistortion on a DPD input signal ($x_{in}[n]$) to improve nonlinearity of the power amplifier 450. The n may be referred to as a sample index of a discrete signal (e.g., $x_{in}$). For example, the DPD input signal ($x_{in}[n]$) may be a digital signal provided from at least one processor (not illustrated). For example, the DPD circuit 410 may generate a DPD output signal ($x_{out}[n]$) based on performing predistortion on the DPD input signal ($x_{in}[n]$). For example, the DPD output signal ($x_{out}[n]$) may be a digital signal in which the DPD input signal ($x_{in}[n]$) is predistorted by the DPD circuit 410. Hereinafter, the DPD input signal ($x_{in}[n]$) provided from the at least one processor may be referred to as a digital signal.

For example, the DAC 440 may perform analog conversion on a DPD output signal ($x_{out}[n]$) provided from the DPD circuit 410. For example, the DAC 440 may generate an amplifier input signal based on analog conversion on the DPD output signal ($x_{out}[n]$). For example, the amplifier input signal may be an analog signal.

For example, the power amplifier 450 may perform amplification on the amplifier input signal provided from the DAC 440. For example, the power amplifier 450 may generate an amplifier output signal ($y(t)$) based on amplification with respect to the amplifier input signal. For example, the t may represent time of a continuous signal (e.g., y). For example, the amplifier output signal ($y(t)$) may be an analog signal. Hereinafter, the amplifier output signal ($y(t)$) may be referred to as an output signal.

For example, the coupler 455 may provide the amplifier output signal ($y(t)$) of the power amplifier 450 to the DPD circuit 410 or the at least one processor through a feedback path. For example, the coupler 455 may provide, to the ADC 445 on the feedback path, the amplifier output signal ($y(t)$) used to identify calibration for the transmission path or an inverse function coefficient of a DPD actuator 430. For example, the feedback path may also be referred to as a feedback circuit.

For example, the ADC 445 may perform digital conversion on the amplifier output signal ($y(t)$) provided from the power amplifier 450 through the coupler 455. For example, the ADC 445 may generate a feedback signal ($y[n]$) based on digital conversion on the amplifier output signal ($y(t)$). For example, the feedback signal ($y[n]$) may be a digital signal to which the amplifier output signal ($y(t)$) is converted. For example, the feedback signal ($y[n]$) may be provided to the DPD circuit 410 or the at least one processor.

For example, the isolator 460 may represent a passive element for providing the amplifier output signal (y(t)) provided from the power amplifier 450 to the filter 465 and the transmission antenna 470. For example, the isolator 460 may be used to fix a flow of the amplifier output signal (y(t)) in a single direction. The isolator 460 may control such that a signal is not introduced into the power amplifier 450 (or the coupler 455) from the transmission antenna 470 and the filter 465.

For example, the filter 465 may perform filtering on the amplifier output signal (y(t)) provided from the isolator 460. For example, the filter 465 may include a band pass filter (BPF). For example, the transmission antenna 470 may radiate a signal filtered with respect to the amplifier output signal (y(t)). For example, the transmission antenna 470 may transmit the filtered amplifier output signal (y(t)) to an external electronic device (not illustrated) (e.g., the terminal 120 of FIG. 1).

For example, the DPD circuit 410 may include a DPD actuator 430 and a DPD coefficient estimator 435. For example, the DPD actuator 430 may be referred to as an actuator, a DPD actuator part, or an actuator part. For example, the DPD coefficient estimator 435 may be referred to as a DPD engine, a DPD coefficient engine, an adaptation part, or a DPD adaptation engine.

For example, the DPD actuator 430 may perform predistortion on the DPD input signal ($x_{in}[n]$) based on an inverse function coefficient provided from the DPD coefficient estimator 435. For example, the DPD coefficient estimator 435 may estimate the inverse function coefficient based on at least one of the DPD input signal ($x_{in}[n]$), the DPD output signal ($x_{out}[n]$), or the feedback signal (y[n]). For example, the DPD coefficient estimator 435 may obtain (or capture (capture)) at least a portion of the DPD input signal ($x_{in}[n]$). Also, the DPD coefficient estimator 435 may obtain (or capture) at least a portion of the DPD output signal ($x_{out}[n]$). For example, the DPD coefficient estimator 435 may obtain the feedback signal (y[n]) through the feedback path. For example, the inverse function coefficient may represent an inverse function characteristic for a nonlinear characteristic of the power amplifier 450. For example, the inverse function coefficient may include a look-up table (LUT). For example, the inverse function coefficient may be referred to as an inverse function characteristic or a DPD coefficient. For example, the inverse function coefficient may be stored in a buffer of the DPD actuator 430.

Although not illustrated in FIG. 4B, for example, the DPD actuator 430 may include at least one of adder, multiplier, buffer, or delay block. For example, the buffer may be referred to as memory or buffer memory. For example, the DPD actuator 430 may be implemented with hardware circuitries. For example, the DPD coefficient estimator 435 may also be implemented as a function of the at least one processor. The function may include modeling a characteristic of the power amplifier 450 as an inverse function to identify the inverse function coefficient.

For effective compensation of nonlinearity and a memory effect of the power amplifier 450, delayed signal components within a specific time domain may be required. The delayed signal components may be referred to as samples. In other words, for modeling the DPD output signal ($x_{out}[n]$) of the DPD circuit 410, feedback signals at past time points may be used. A relationship between the DPD output signal ($x_{out}[n]$) and the feedback signals is as shown in the following equation.

[Equation 1]

$$x_{OUT}[n] = f\{y[n], y[n-1], \cdots, y[n-N]\}$$

The $x_{out}[n]$ may indicate an output signal of the DPD circuit 410, the f may indicate an inverse function of the power amplifier 450, the y[n] may indicate a feedback signal, and the N may indicate a maximum delay of the DPD circuit 410. Referring to the above description, the DPD coefficient estimator 435 may use signals at past time points to model the inverse function coefficient. The equation describes a relationship between the DPD output signal ($x_{out}[n]$) of the DPD circuit 410 and the feedback signal (y[n]), but the DPD output signal ($x_{out}[n]$) may also use current and past DPD input signals.

Referring to the above description, as a length of the N becomes longer (that is, by using a long delay range), the DPD circuit 410 may effectively compensate for a memory effect of the power amplifier 450. However, as the length of the N becomes longer, a computational load of the DPD coefficient estimator 435 for calculating the N may increase. Also, in order to configure the N in hardware, a plurality of multipliers and a plurality of buffers (e.g., N+1) are required, and thus a structure of the DPD actuator 430 may become complicated. Accordingly, hardware and software resources required for the electronic device 400 to transmit a signal through the power amplifier 450 may increase. Also, according to a structural limitation of the DPD circuit 410, only signals within a limited delay range may be used. For example, according to a structural limitation (e.g., the number of buffers) of the DPD actuator 430, signals outside the limited delay range cannot be used, and thus memory components (or distortion components) according to signals outside the delay range cannot be compensated. Accordingly, performance of the DPD circuit 410 may be degraded.

Hereinafter, an electronic device and a method according to embodiments of the present disclosure may use a DPD circuit including a plurality of paths. The plurality of paths may be driven with different sampling rates. For example, a DPD circuit including two paths may support a dual rate. However, embodiments of the present disclosure are not limited thereto. An electronic device and a method according to embodiments of the present disclosure may include a path for adjusting a sampling rate of a digital signal. By adjusting the sampling rate, the electronic device and the method according to embodiments of the present disclosure may perform compensation for a substantially expanded delay range despite a structural limitation of the DPD circuit. Accordingly, the electronic device and the method according to embodiments of the present disclosure may improve a compensation capability of the DPD circuit and achieve linearization of a power amplifier.

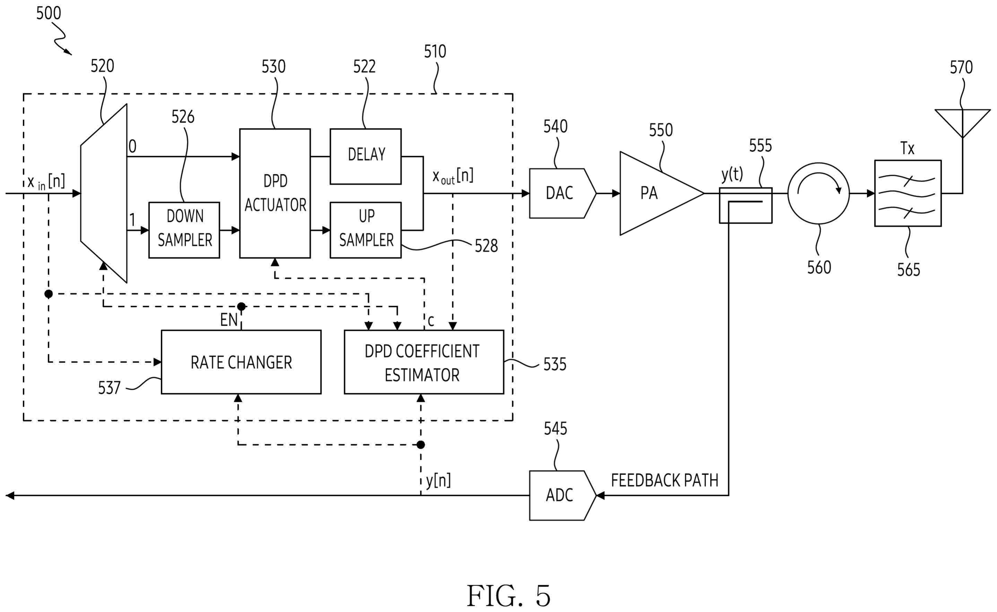

FIG. 5 illustrates an example of a DPD circuit including a plurality of DPD paths according to embodiments.

FIG. 5 illustrates an example of an electronic device 500 including a DPD circuit 510. For example, the electronic device 500 may include the RU 220 of FIG. 2. However, embodiments of the present disclosure are not limited thereto. For example, at least a portion of the electronic device 500 may be implemented in the base station 110 of FIG. 1 or the DU 210 of FIG. 2.

Referring to FIG. 5, according to an embodiment, the electronic device 500 may include a plurality of components for transmitting a signal. For example, the electronic device 500 may include a DPD circuit 510, a digital to analog converter (DAC) 540, an analog to digital converter (ADC) 545, a power amplifier 550, a coupler 555, an isolator 560, a filter 565, and a transmission antenna 570. For example, at least a portion of the plurality of components may be included in a transmission path. The transmission path may indicate a path for the electronic device 500 to radiate a transmission signal to an outside. For example, the transmission signal may be referred to as a signal radiated through the transmission antenna. FIG. 5 illustrates an example of one transmission path included in the electronic device 500, but embodiments of the present disclosure are not limited thereto. For example, the electronic device 500 may include a plurality of transmission paths. For example, each of the plurality of transmission paths may include the plurality of components.

For example, the DPD circuit 510 may indicate a circuit for performing predistortion on a DPD input signal ($x_{in}[n]$) to improve nonlinearity of the power amplifier 550. The n may be referred to as a sample index of a discrete signal (e.g., $x_{in}$). For example, the DPD input signal ($x_{in}[n]$) may be a digital signal provided from at least one processor (not illustrated). For example, the DPD circuit 510 may generate a DPD output signal ($x_{out}[n]$) based on performing predistortion on the DPD input signal ($x_{in}[n]$). For example, the DPD output signal ($x_{out}[n]$) may be a digital signal in which the DPD input signal ($x_{in}[n]$) is predistorted by the DPD circuit 510. Hereinafter, the DPD input signal ($x_{in}[n]$) provided from the at least one processor may be referred to as a digital signal.

For example, the DAC 540 may perform analog conversion on the DPD output signal ($x_{out}[n]$) provided from the DPD circuit 510. For example, the DAC 540 may generate an amplifier input signal based on analog conversion on the DPD output signal ($x_{out}[n]$). For example, the amplifier input signal may be an analog signal.

For example, the power amplifier 550 may perform amplification on the amplifier input signal provided from the DAC 540. For example, the power amplifier 550 may generate an amplifier output signal ($y(t)$) based on amplification with respect to the amplifier input signal. For example, the t may indicate time of a continuous signal (e.g., y). For example, the amplifier output signal ($y(t)$) may be an analog signal. Hereinafter, the amplifier output signal ($y(t)$) may be referred to as an output signal.

For example, the coupler 555 may provide the amplifier output signal ($y(t)$) of the power amplifier 550 to the DPD circuit 510 or the at least one processor through a feedback path. For example, the coupler 555 may provide, to the ADC 545 on the feedback path, the amplifier output signal ($y(t)$) used to identify calibration for the transmission path or an inverse function coefficient of the DPD actuator 530. For example, the feedback path may also be referred to as a feedback circuit.

For example, the ADC 545 may perform digital conversion on the amplifier output signal ($y(t)$) provided from the power amplifier 550 through the coupler 555. For example, the ADC 545 may generate a feedback signal ($y[n]$) based on digital conversion of the amplifier output signal ($y(t)$). For example, the feedback signal ($y[n]$) may be a digital signal in which the amplifier output signal ($y(t)$) is converted. For example, the feedback signal ($y[n]$) may be provided to the DPD circuit 510 or the at least one processor.

For example, the isolator 560 may indicate a passive element for providing the amplifier output signal ($y(t)$) provided from the power amplifier 550 to the filter 565 and the transmission antenna 570. For example, the isolator 560 may be used to fix a flow of the amplifier output signal ($y(t)$) in a single direction. The isolator 560 may control such that a signal is not introduced into the power amplifier 550 (or the coupler 555) from the transmission antenna 570 and the filter 565.

For example, the filter 565 may perform filtering on the amplifier output signal ($y(t)$) provided from the isolator 560. For example, the filter 565 may include a band pass filter (BPF). For example, the transmission antenna 570 may radiate a signal filtered with respect to the amplifier output signal ($y(t)$). For example, the transmission antenna 570 may transmit the filtered amplifier output signal ($y(t)$) to an external electronic device (not illustrated) (e.g., the terminal 120 of FIG. 1).

According to an embodiment, the DPD circuit 510 may include a switch 520, a delay block 522, a down sampler 526, an up sampler 528, a DPD actuator 530, a DPD coefficient estimator 535, and a rate changer 537. For example, the DPD actuator 530 may be referred to as an actuator, a DPD actuator part, or an actuator part. For example, the DPD coefficient estimator 535 may be referred to as a DPD engine, a DPD coefficient engine, an adaptation part, or a DPD adaptation engine.

According to an embodiment, the switch 520 may select, among a plurality of paths included in the DPD circuit 510, a path for processing a DPD input signal ($x_{in}[n]$). For example, each of the plurality of paths may be referred to as a DPD path. For example, the switch 520 may be used to select a first DPD path and a second DPD path included in the DPD circuit 510. For example, the switch 520 may include a demultiplexer. For example, an output terminal (0) of the demultiplexer may be connected to the first DPD path, and an output terminal (1) of the demultiplexer may be connected to the second DPD path. The demultiplexer may also be referred to as a data distributor. However, embodiments of the present disclosure are not limited thereto.

According to an embodiment, the switch 520 may select one DPD path among the first DPD path and the second DPD path, based on a control signal (EN) provided from the rate changer 537. For example, based on receiving a control signal having a first value (e.g., 0), the switch 520 may activate the first DPD path and deactivate the second DPD path. In other words, based on the control signal having the first value, the switch 520 may select the first DPD path. Alternatively, based on receiving a control signal having a second value (e.g., 1), the switch 520 may deactivate the first DPD path and activate the second DPD path. In other words, based on the control signal having the second value, the switch 520 may select the second DPD path.

In an example of FIG. 5, the switch 520 may be implemented as a 1x2 demultiplexer that outputs two outputs (e.g., a DPD input signal ($x_{in}[n]$) for the first DPD path (or the second DPD path) and a 0 value output for the second DPD path (or the first DPD path)), based on two inputs (e.g., a control signal and a DPD input signal ($x_{in}[n]$)), but embodiments of the present disclosure are not limited thereto. For example, in a case that the DPD circuit 510 includes four DPD paths, the switch 520 may be implemented as a 1x4 demultiplexer. In this case, each of the four DPD paths may have a magnification for adjusting a sampling rate for a digital signal (e.g., the DPD input signal ($x_{in}[n]$)) that is different from each other. Adjustment of the sampling rate may be understood as adjusting an interval between samples of a digital signal or adjusting the number of samples included in a designated time. The sampling rate may be referred to as a sampling frequency, a sampling speed, or an operating rate.

According to an embodiment, the first DPD path may include a DPD actuator 530 and a delay block 522 connected to an output terminal (0) of the switch 520. Also, the second DPD path may include a down sampler 526, a DPD actuator 530, and an up sampler 528 connected to another output terminal (1) of the switch 520. For example, the first DPD path may be referred to as a first path or a path. Also, for example, the second DPD path may be referred to as a second path or a sampling path.

According to an embodiment, the first DPD path may provide predistortion and delay compensation for the DPD input signal ($x_{in}[n]$) without changing a sampling rate of the DPD input signal ($x_{in}[n]$). According to an embodiment, the second DPD path may provide a change (or adjustment) of a sampling rate for the DPD input signal ($x_{in}[n]$) (e.g., down sampling), predistortion for the DPD input signal ($x_{in}[n]$) having the changed sampling rate, and a change (or adjustment) of a sampling rate for the predistorted DPD input signal ($x_{in}[n]$) (e.g., up sampling).

According to an embodiment, the DPD actuator 530 may perform predistortion on the DPD input signal ($x_{in}[n]$), based on an inverse function coefficient (c) provided from the DPD coefficient estimator 535. For example, the DPD actuator 530 may perform predistortion on the DPD input signal ($x_{in}[n]$) provided through the first DPD path. Alternatively, for example, the DPD actuator 530 may perform predistortion on a DPD input signal ($x_{in}[n]$) at which a sampling rate provided through the second DPD path is adjusted. In this case, the DPD actuator 530 may use a first inverse function coefficient (c1) in performing the predistortion based on the first DPD path. Unlike this, the DPD actuator 530 may use a second inverse function coefficient (c2), different from the first inverse function coefficient, when performing the predistortion based on the second DPD path. For example, the second inverse function coefficient (c2) may be identified based on an adjustment magnification of the sampling rate provided by the second DPD path.

According to an embodiment, the down sampler 526 and the up sampler 528 may adjust a sampling rate for the DPD input signal ($x_{in}[n]$). For example, the down sampler 526 may decrease a sampling rate for the DPD input signal ($x_{in}[n]$) (or down sampling). For example, the up sampler 528 may increase a sampling rate for the DPD input signal ($x_{in}[n]$) on which predistortion is performed by the DPD actuator 530 (or an output signal of the DPD actuator 530) (or up sampling). Referring to the above description, when a sampling rate of the DPD input signal ($x_{in}[n]$) provided to the DPD actuator 530 through the first DPD path is a first sampling rate (e.g., k), a sampling rate of the DPD input signal ($x_{in}[n]$) provided to the DPD actuator 530 through the second DPD path may be a second sampling rate (e.g., k/2, k/3, k/4) decreased by an integer-factor (e.g., x2, x3, x4) from the first sampling rate by the down sampler 526. Thereafter, a sampling rate of the DPD input signal ($x_{in}[n]$) on which predistortion is performed based on the second DPD path may be the first sampling rate (e.g., k) increased by an integer-factor (e.g., x2, x3, x4) from the second sampling rate by the up sampler 528. The first sampling rate increased by the up sampler 528 may correspond to an operating rate of the DAC 540.

According to an embodiment, the delay block 522 may compensate for a delay between the first DPD path and the second DPD path. For example, the delay may include a processing delay between the first DPD path and the second DPD path.

According to an embodiment, the DPD coefficient estimator 535 may estimate the inverse function coefficient based on at least one of the DPD input signal ($x_{in}[n]$), the DPD output signal ($x_{out}[n]$), or the feedback signal (y[n]). For example, the DPD coefficient estimator 535 may obtain (or capture) at least a portion of the DPD input signal ($x_{in}[n]$). Also,

the DPD coefficient estimator 535 may obtain (or capture) at least a portion of the DPD output signal ($x_{out}[n]$). For example, the DPD coefficient estimator 535 may obtain the feedback signal ($y[n]$) through the feedback path. For example, the inverse function coefficient may indicate an inverse function characteristic for a nonlinear characteristic of the power amplifier 550. For example, the inverse function coefficient may include a look-up table (LUT). For example, the inverse function coefficient may be referred to as an inverse function characteristic or a DPD coefficient. For example, the inverse function coefficient may be stored in a buffer of the DPD actuator 530.

According to an embodiment, the estimated inverse function coefficient may be sampled based on a sampling rate of the second DPD path. For example, the inverse function coefficient estimated based on at least one of the DPD input signal ($x_{in}[n]$), the DPD output signal ($x_{out}[n]$), or the feedback signal ($y[n]$) may be an inverse function coefficient to be used for the first DPD path in which sampling is not considered. In response to identifying that the second path is used, the DPD coefficient estimator 535 may sample the estimated inverse function coefficient based on the sampling rate of the second path. That the second path is used may be identified based on a value of a control signal (EN) received from the rate changer 537. The sampled inverse function coefficient may be an inverse function coefficient to be used for the second DPD path. Referring to the above description, the inverse function coefficient may be identified based on an adjustment magnification of a sampling rate of the down sampler 526 (or the up sampler 528) of the second DPD path.

According to an embodiment, the rate changer 537 may generate a control signal (EN) indicating a DPD path to be activated among the first DPD path and the second DPD path. For example, the control signal (EN) may be used, by the switch 520, to select (or activate, identify) one DPD path among the first DPD path and the second DPD path. According to an embodiment, the control signal (EN) may be used to set a sampling rate for the DPD actuator 530. For example, as the control signal (EN) is provided to the DPD coefficient estimator 535, the control signal (EN) may be used to identify an inverse function coefficient of the DPD actuator 530. Accordingly, by identifying the inverse function coefficient performed based on the control signal (EN), a sampling rate for the DPD actuator 530 may be set. The sampling rate for the DPD actuator 530 may correspond to an adjustment magnification of a sampling rate of the down sampler 526 and the up sampler 528.

According to an embodiment, the rate changer 537 may identify a value of the control signal based on the DPD input signal ($x_{in}[n]$) and the feedback signal ($y[n]$). For example, the rate changer 537 may identify an error correlation to detect that memory compensation is required at a sample delay (or a sample index) longer than a maximum delay (N) of the DPD actuator 530. In other words, the rate changer 537 may calculate the error correlation to detect that memory compensation of a specific value or more is required in a region incapable of compensating based on the DPD actuator 530. For example, the error correlation may indicate a correlation value between a difference between the DPD input signal ($x_{in}[n]$) and the feedback signal ($y[n]$) and the DPD input signal ($x_{in}[n]$). The error correlation may be defined as the following equation.

[Equation 2]

$$Corr[m] = \frac{1}{N_C} \sum_{n=0}^{N_C-1} e^*[n+m]\, x_{in}[n], \qquad where\ e[n] = x_{in}[n] - y[n]$$

The Corr[m] may indicate an error correlation for a sample having a sample index m, the $N_c$ may indicate the number of designated samples used to calculate the error correlation, the $e^*$ may indicate a complex conjugate, the $x_{in}[n]$ may indicate a DPD input signal, and the $y[n]$ may represent a feedback signal.

Referring to the above description, the rate changer 537 may identify a correlation value of the DPD input signal ($xin[n]$) with respect to a difference (or an error) between the DPD input signal ($x_{in}[n]$) and the feedback signal ($y[n]$) (that is, the error correlation). According to an embodiment, the rate changer 537 may set a value of the control signal to 1 based on the error correlation (Corr[m]) and a reference value ($\gamma$). For example, a relationship between the error correlation (Corr[m]) and the reference value ($\gamma$) may be defined as the following equation.

[Equation 3]

$$\frac{|Corr[\hat{m}]|}{|Corr[0]|} \geq \gamma, \qquad where\ \hat{m} = arg\max_{m}\{|Corr[m]| \mid m \geq N\}$$

The $\hat{m}$ may indicate an m at which the error correlation (Corr[m]) is maximum for samples (m) equal to or greater than a maximum delay (N), the Corr[$\hat{m}$] may indicate an error correlation having a maximum value among the error correlations corresponding to the samples equal to or greater than the maximum delay, the Corr[0] may indicate an error correlation for a current sample, and the $\gamma$ may indicate a threshold value designated for a ratio of the error correlations (Corr[$\hat{m}$] and Corr[0]). The Corr[0] may be referred to as a reference correlation value.

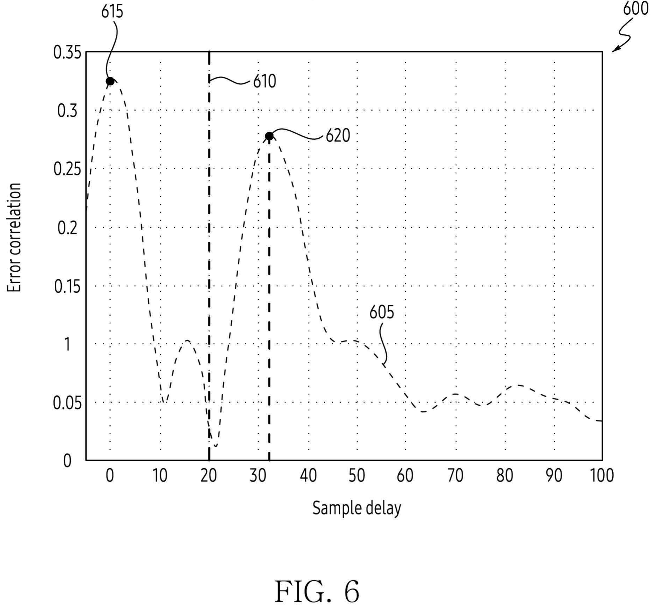

Referring to the above description, the rate changer 537 may set a value of the control signal to 1, based on identifying that a ratio between a maximum correlation value and a current correlation value among samples equal to or greater than a maximum delay (N) is equal to or greater than the reference value ($\gamma$). Identification of the maximum correlation value (Corr[$\hat{m}$]) among the samples equal to or greater than the maximum delay may be referred to in FIG. 6.

FIG. 6 illustrates an example of a graph indicating correlation values for samples according to embodiments.

FIG. 6 illustrates a graph 600 indicating an error correlation of a sample corresponding to a sample delay identified by the DPD circuit 510. For example, the error correlation may be identified based on a rate changer 537 of the DPD circuit 510. A horizontal axis of the graph 600 may indicate a sample delay (or a sample corresponding to the sample delay), and a vertical axis may indicate an error correlation (or a correlation value of a DPD input signal with respect to a difference between a DPD input signal and a feedback signal).

Referring to the graph 600, a line 605 indicating an error correlation according to a sample delay and a line 610 indicating a maximum delay (e.g., N=20) of the DPD circuit 510 (or the DPD actuator 530) are illustrated. For example, referring to the line 605, at a point 615 at which a sample delay is 0, an error correlation for a current sample may be approximately 0.33. The error correlation for the current sample may indicate Corr[0] in the above-described equation of FIG. 5. Also, referring to the line 605, a point 620 at which an error correlation for sample delays (or samples) equal to or greater than a maximum delay (N=20) is maximum (or a peak) may be a point corresponding to a sample (m=33). For example, an error correlation at the point 620 may be approximately 0.275. For example, when assuming that the threshold value ($\gamma$) is 0.7, a ratio according to the Equation 3 may be approximately 0.833 (=0.275/0.33), which may be equal to or greater than the threshold value ($\gamma$). Accordingly, the rate changer 537 may set a value of the control signal (EN) to 1.

Referring back to FIG. 5, according to an embodiment, the rate changer 537 may set a value of the control signal (EN) to 1, based on identifying whether the ratio identified based on a correlation value for the DPD input signal ($x_{in}[n]$) and the feedback signal ($y[n]$) is equal to or greater than the reference value ($\gamma$). The control signal having a value of 1 may be provided to the switch 520 and the DPD coefficient estimator 535.

Although not illustrated in FIG. 5, for example, the DPD actuator 530 may include at least one of adder, multiplier, buffer, or delay block. For example, the buffer may be referred to as memory or buffer memory. For example, the DPD actuator 530 may be implemented with hardware circuitries. For example, the DPD coefficient estimator 535 may also be implemented as a function of the at least one processor. The function may include modeling a characteristic of the power amplifier 550 as an inverse function to identify the inverse function coefficient. Also, for example, the rate changer 537 may also be implemented as a function of the at least one processor. For example, the function may include generating a control signal for identifying (or activating) a DPD path to be used among the first DPD path and the second DPD path.

Referring to the above description, the electronic device 500 may improve linearity of the power amplifier 550 by performing predistortion on the DPD input signal ($x_{in}[n]$) through the DPD circuit 510. According to an embodiment, the electronic device 500 may use a path (e.g., the second DPD path) capable of adjusting a sampling rate of the DPD input signal ($x_{in}[n]$), based on identifying a correlation value for the DPD input signal ($x_{in}[n]$) and the feedback signal ($y[n]$). By down sampling the sampling rate of the DPD input signal ($x_{in}[n]$) by two times through the second DPD path, a substantial range of memory compensation may be increased by two times. For example, assume a case in which the DPD actuator 530 includes a total of N+1 buffers (e.g., DPD 0 to DPD N) (that is, a maximum delay is N). In a case of the DPD input signal ($x_{in}[n]$) having a first sampling rate, x[n] may be stored in DPD 0, x[n-1] may be stored in DPD 1, ..., and x[n-N] may be stored in DPD N. In contrast, in a case of the DPD input signal ($x_{in}[n]$) having a second sampling rate down sampled by two times with respect to the first sampling rate, x[n] may be stored in DPD 0, x[n-2] may be stored in DPD 1, ..., and x[n-2N] may be stored in DPD N. Accordingly, while the number of buffers (or memory resources) of the DPD actuator 530 actually used is the same, a compensable temporal region may be increased by two times. Therefore, compared with a maximum delay (N) in which predistortion based on the first DPD path that does not adjust the sampling rate is compensable, predistortion based on the second DPD path that adjusts the sampling rate may compensate for a substantially doubled maximum delay (e.g., 2N).

According to an embodiment, the electronic device 500 may perform predistortion on a digital signal (e.g., the DPD input signal ($x_{in}[n]$)) based on a DPD path (e.g., the first DPD path or the second DPD path) identified based on a control signal, and then generate an output signal through the power amplifier 550, and transmit the generated output signal through the transmission antenna 570. For example, the electronic device 500 may generate a first digital signal (e.g., the DPD input signal ($x_{in}[n]$)). For example, the first digital signal may be generated through at least one processor (not illustrated) and may be provided, from the at least one processor, to the DPD circuit 510. In other words, the first digital signal may be a DPD input signal. For example, the electronic device 500 may perform predistortion on the first digital signal based on the first DPD path of the DPD circuit 510. For example, predistortion may be performed on the first digital signal based on the DPD actuator 530. In this case, the DPD actuator 530 may perform predistortion on the first digital signal, based on a first inverse function coefficient. For example, the electronic device 500 may perform delay compensation, through the delay block 522, on the first digital signal on which the predistortion is performed based on the first DPD path. In this case, the first digital signal may have a first sampling rate. Accordingly, a first digital signal on which the delay compensation is performed may be referred to as a DPD output signal (e.g., the DPD output signal ($x_{out}[n]$)) of the DPD circuit 510. The DPD output signal may be analog converted based on the DAC 540. The analog-converted DPD output signal may be inputted to the power amplifier 550. The analog-converted DPD output signal may be referred to as an input signal (or an amplifier input signal) of the power amplifier 550. Accordingly, the power amplifier 550 may generate a first output signal (or an amplifier output signal). The first output signal may be transmitted through the transmission antenna 570 after passing through the isolator 560 and the filter 565. In this case, the first output signal may be provided to the ADC 545 through a feedback path. The first output signal may be digital converted based on the ADC 545. The digital converted first output signal may be referred to as a feedback signal (e.g., the feedback signal ($y[n]$)). The rate changer 537 (or the at least one processor) may identify a correlation value for the first digital signal and the feedback signal. The rate changer 537 may compare a ratio of correlation values identified based on the correlation value with a reference value. The rate changer 537 may generate a control signal (EN) (e.g., a control signal having a value of 1) for deactivating the first DPD path and activating the second DPD path, based on the ratio being equal to or greater than the reference value.

For example, the electronic device 500 may generate a second digital signal subsequent to the first digital signal. For example, the second digital signal may be generated through at least one processor (not illustrated) and may be provided, from the at least one processor, to the DPD circuit 510. In other words, the second digital signal may be a DPD input signal. For example, the electronic device 500 may perform predistortion on the second digital signal, based on the second DPD path activated based on the control signal. For example, a sampling rate of the second digital signal may be down sampled by the down sampler 526 included in the second DPD path. For example, the down-sampled second digital signal may have a second sampling rate decreased by an integer-factor with respect to the first sampling rate. Thereafter, predistortion may be performed on the down-sampled second digital signal by the DPD actuator 530. In this case, the DPD actuator 530 may perform predistortion on the second digital signal, based on a second inverse function coefficient. The first inverse function coefficient may be estimated by the feedback signal, the first digital signal, and the DPD output signal associated with the first digital signal. The second inverse function coefficient may be a value sampled with respect to the first inverse function coefficient, based on the control signal indicating the second DPD path. Accordingly, the second digital signal on which the predistortion is performed may be up sampled by the up sampler 528. The up-sampled second digital signal may have the first sampling rate adjusted from the second sampling rate. Thereafter, the up-sampled second digital signal may be analog converted by the DAC 540. The analog-converted second digital signal may be referred to as an input signal (or an amplifier input signal) of the power amplifier 550. The power amplifier 550 may generate a second output signal (or an amplifier output signal) from the analog-converted second digital signal. The second output signal may be transmitted through the transmission antenna 570 after passing through the isolator 560 and the filter 565.

According to an embodiment, the first digital signal and the second digital signal of the above example may be generated based on the same carrier configuration information (or expansion information). For example, the electronic device 500 may receive the carrier configuration information (or expansion information) from a DU (e.g., the DU 220 of FIG. 2). Based on the carrier configuration information, the electronic device 500 may generate the first digital signal and the second digital signal. In this case, predistortion may be performed on the first digital signal based on the first DPD path, and predistortion may be performed on the second digital signal based on the second DPD path. A third digital signal subsequent to the second digital signal may be predistorted based on the second DPD path. According to an embodiment, in a case that other carrier configuration information is received from the DU, the electronic device 500 may generate a control signal having a value of 0. For example, the rate changer 537 may generate a control signal having a value of 0 and may provide the control signal to the switch 520 and the DPD coefficient estimator 535. Accordingly, the DPD circuit 510 in the electronic device 500 may use the first DPD path again. A fourth digital signal generated by the electronic device 500 based on the other carrier configuration information may be predistorted through the first DPD path. In a case that the second DPD path is activated (that is, a control signal having a value of 1) based on the fourth digital signal, predistortion may be performed again based on the second DPD path on a fifth digital signal subsequent to the fourth digital signal. For example, the carrier configuration information may include frequency information of a transmission signal. For example, the frequency information may include at least one of an instantaneous bandwidth (IBW) or an occupied bandwidth (OBW) of the transmission signal. The transmission signal may indicate a signal of a physical layer transmitted through a transmission path of the electronic device 500.

According to an embodiment, the electronic device 500 may perform delay compensation through the delay block 522, in a case that processing for a digital signal is performed by using the first DPD path changed from the second DPD path. For example, in a case that the activated second DPD path is deactivated and the deactivated first DPD path is activated based on the carrier configuration information, the electronic device 500 may perform the delay compensation through the delay block 522. While using the second DPD path, time for processing of the down sampler 526 and the up sampler 528 may occur. In a case of using the first DPD path changed based on the carrier configuration information while using the second DPD path, compensation for the time on the second DPD path may be required. This may be for resolving asynchronization of an output signal. Accordingly, the electronic device 500 may perform compensation for the time (that is, delay compensation) that may occur in the second DPD path through the delay block 522.

In FIG. 5, an embodiment for one transmission path among a plurality of transmission paths included in the electronic device 500 has been described, but embodiments of the present disclosure are not limited thereto. When a transmission path illustrated in FIG. 5 is referred to as a first transmission path and another transmission path not illustrated in FIG. 5 is referred to as a second transmission path, the electronic device 500 according to an embodiment may further include a DPD circuit 510 for the first transmission path and another DPD circuit (not illustrated) for the second transmission path. For example, the another DPD circuit may include a third DPD path and a fourth DPD path. The third DPD path may correspond to the first DPD path of the DPD circuit 510, and the fourth DPD path may correspond to the second DPD path of the DPD circuit 510. In other words, the third DPD path may indicate a path that does not perform adjustment of a sampling rate, and the fourth DPD path may indicate a path that performs adjustment of a sampling rate. However, an adjustment magnification of a sampling rate according to the fourth DPD path may be different from an adjustment magnification of a sampling rate of the second DPD path. This is because the adjustment magnification may be determined based on a characteristic of another power amplifier connected to another transmission antenna, different from the transmission antenna 570 included in the second transmission path. For example, assume a case in which the first digital signal having a first sampling rate is provided to the first transmission path and the second transmission path. In a case that the first digital signal is provided to the second DPD path in the DPD circuit 510 of the first transmission path, a sampling rate of the first digital signal may be down sampled to a second sampling rate. Thereafter, the first digital signal having the second sampling rate may be predistorted. In contrast, in a case that the first digital signal is provided to the fourth DPD path in the another DPD circuit of the second transmission path, a sampling rate of the first digital signal may be down sampled to a third sampling rate. Thereafter, the first digital signal having the third sampling rate may be predistorted. In this case, each of the second sampling rate and the third sampling rate may indicate a sampling rate decreased by an integer-factor (or down sampled) with respect to the first sampling rate. For example, the transmission antenna 570 of the first transmission path and the another transmission antenna of the second transmission path may be included in an antenna array.

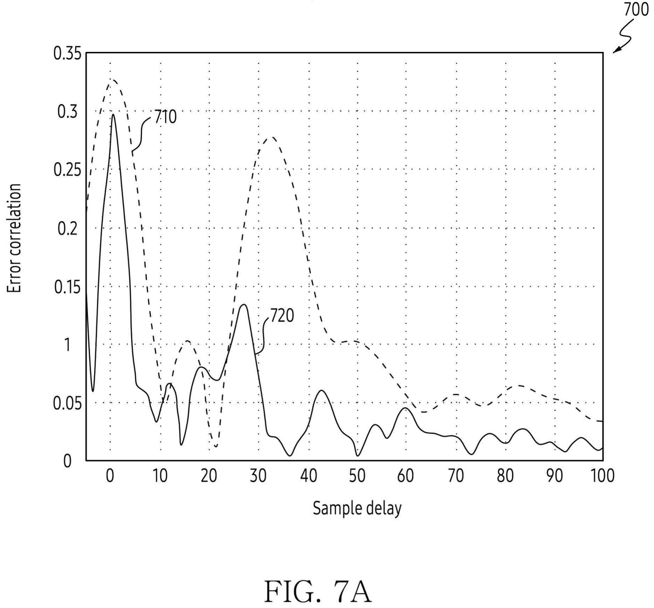

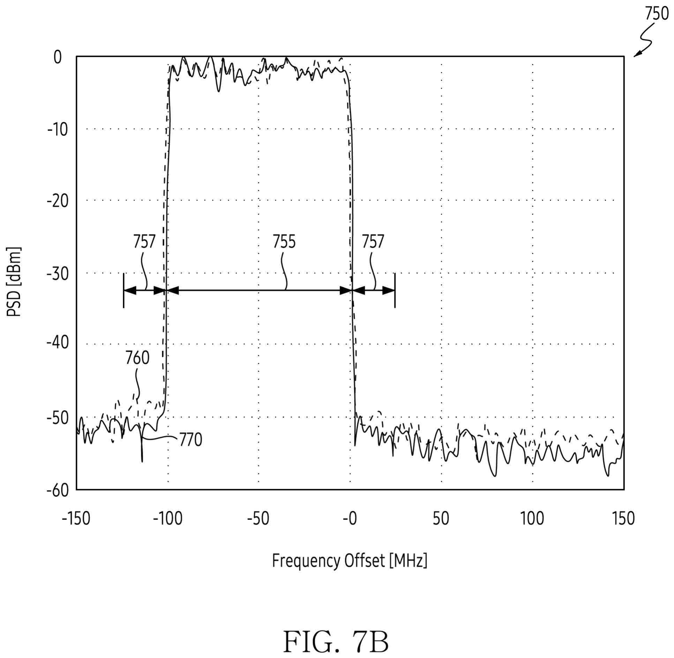

FIGS. 7A and 7B illustrate examples of graphs indicating transmission performance based on a DPD circuit including a plurality of DPD paths according to embodiments.

FIGS. 7A and 7B illustrate graphs 700 and 750 for indicating transmission performance based on a DPD circuit including a plurality of DPD paths (e.g., the DPD circuit 510 of FIG. 5). The transmission performance may indicate transmission performance for a signal predistorted based on each of the plurality of DPD paths (e.g., the first DPD path and the second DPD path). For example, a digital signal passing through the first DPD path may have a first sampling rate (e.g., approximately 1000 MHz). For example, a digital signal passing through the second DPD path may have a second sampling rate (e.g., approximately 500 MHz) decreased by two times with respect to the first sampling rate. A maximum delay (N) of a DPD actuator (e.g., the DPD actuator 530) included in the first DPD path and the second DPD path is assumed to be 20.

Referring to FIG. 7A, the graph 700 illustrates a first line 710 indicating transmission performance based on the first DPD path and a second line 720 indicating transmission performance based on the second DPD path. A horizontal axis of the graph 700 may indicate a sample delay (or a sample corresponding to the sample delay), and a vertical axis of the graph 700 may indicate an error correlation (or a correlation value of a DPD input signal with respect to a difference between the DPD input signal and a feedback signal).

Referring to the graph 700, the second line 720 may have, overall, a smaller error correlation, compared to the first line 710. For example, the second line 720 may have a lower error correlation than the first line 710 at samples corresponding to sample delays equal to or greater than the maximum delay. The error correlation may indicate how much of DPD input signals are included in a difference (or an error) between a DPD input signal and a feedback signal. In other words, as the error correlation becomes smaller, it may indicate that there is no relationship between the difference and the DPD input signal. That is, as the error correlation becomes smaller, it may indicate that an influence due to an error is smaller, and may be understood that transmission performance is improved.

Referring to FIG. 7B, the graph 750 illustrates a third line 760 indicating transmission performance based on the first DPD path and a fourth line 770 indicating transmission performance based on the second DPD path. A horizontal axis of the graph 750 may indicate a frequency offset (unit: MHz), and a vertical axis of the graph 750 may indicate a power spectral density (PSD) (unit: dBm).

Referring to the graph 750, the fourth line 770 may have a lower output level in a region 757 adjacent to a bandwidth 755 of a transmission signal, compared to the third line 760. For example, a PSD value of the fourth line 770 may be lower than a PSD value of the third line 760 in the adjacent region 757. The PSD may indicate an amount (or a level) of energy according to frequency. In other words, as the PSD value becomes smaller, it may indicate that an energy level at a corresponding frequency is lower. That is, a lower output level in the adjacent region 757 may indicate that a transmission signal component in an undesired frequency region is lower, and it may be understood that transmission performance is improved.

Referring to FIGS. 7A and 7B, predistortion using a DPD circuit (or a dual rate DPD circuit) including a plurality of DPD paths according to embodiments of the present disclosure may improve linearity of a power amplifier. Accordingly, the electronic device and the method according to embodiments of the present disclosure may secure improved transmission quality.

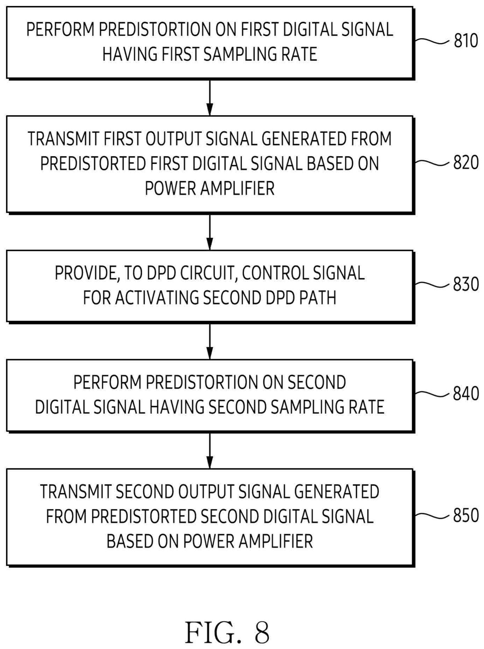

FIG. 8 illustrates an example of an operation flow for a method of transmitting a signal based on a DPD circuit including a plurality of DPD paths according to embodiments.

At least a portion of the method of FIG. 8 may be performed by the electronic device 500 of FIG. 5. For example, at least a portion of the method may be controlled by at least one processor of the electronic device 500.

Referring to FIG. 8, in operation 810, the electronic device 500 may perform predistortion on a first digital signal having a first sampling rate. For example, the electronic device 500 may perform the predistortion on the first digital signal generated from the at least one processor through a first DPD path among the plurality of DPD paths. For example, the first digital signal may be provided to a DPD actuator (e.g., the DPD actuator 530 of FIG. 5) of the first DPD path selected based on a switch (e.g., the switch 520 of FIG. 5). Based on the first DPD path, predistortion on the first digital signal may be performed. For example, the first digital signal may have the first sampling rate.

In operation 820, the electronic device 500 may transmit a first output signal generated from the predistorted first digital signal based on a power amplifier (e.g., the power amplifier 550 of FIG. 5). For example, the predistorted first digital signal may have a delay compensated by a delay block of the first DPD path. For example, the delay may include a processing delay between the first DPD path and the second DPD path. For example, the first digital signal on which the delay is compensated may be analog converted by a DAC (e.g., the DAC 540 of FIG. 5). A first input signal analog-converted by the DAC from the first digital signal may be provided to the power amplifier. The power amplifier may generate the first output signal from the first input signal. The first output signal may be transmitted through the transmission antenna 570 after passing through the isolator 560 and the filter 565.

According to an embodiment, the first output signal may be provided to the DPD circuit through a feedback path. For example, the first output signal may be provided to the feedback path based on a coupler connected to an output terminal of the power amplifier. The first output signal may be digital converted by an ADC (e.g., the ADC 545) of the feedback path. The ADC may generate a feedback signal digital converted from the first output signal. The feedback signal may be provided to a DPD coefficient estimator (e.g., the DPD coefficient estimator 535 of FIG. 5) and a rate changer (e.g., the rate changer 537 of FIG. 5) of the DPD circuit.

In operation 830, the electronic device 500 may provide, to the DPD circuit, a control signal for activating the second DPD path.

According to an embodiment, the rate changer may identify a value of the control signal based on the first digital signal and the feedback signal. For example, the rate changer may identify an error correlation to detect that memory compensation is required at a sample delay (or a sample index) longer than a maximum delay (N) of the DPD actuator. For example, the error correlation may indicate a correlation value between a difference between the first digital signal and the feedback signal and the first digital signal. For example, the rate changer may identify whether a ratio of correlation values identified based on the error correlation is equal to or greater than the reference value. The ratio may indicate a ratio between a maximum correlation value among correlation values corresponding to samples equal to or greater than the maximum delay and a correlation value of a current sample. The maximum delay may indicate a maximum delay for the DPD actuator. For example, the rate changer may generate the control signal for activating the second DPD path among the first DPD path and the second DPD path, based on identifying that the ratio is equal to or greater than the reference value. For example, the control signal for activating the second DPD path may have a value of 1. For example, the control signal having the value of 1 may be used to deactivate the first DPD path and activate the second DPD path. For example, a control signal having a value of 0 may be used to activate the first DPD path and deactivate the second DPD path.

According to an embodiment, an inverse function coefficient for a DPD actuator may be identified based on the control signal having a value of 1. For example, the rate changer may provide the control signal to the DPD coefficient estimator. Based on the control signal having the value of 1, the DPD coefficient estimator may sample the inverse function coefficient. A sampling ratio for the inverse function coefficient may correspond to an adjustment magnification of a sampling rate of the second DPD path.

In operation 840, the electronic device 500 may perform predistortion on a second digital signal having a second sampling rate. For example, the electronic device 500 may perform the predistortion on the second digital signal subsequent to the first digital signal generated from the at least one processor, through the second DPD path among the plurality of DPD paths. For example, the second digital signal may be provided to a DPD actuator of the second DPD path selected through the switch based on the control signal having the value of 1. An inverse function coefficient of the DPD actuator of the second DPD path may be different from an inverse function coefficient of the DPD actuator of the first DPD path. In other words, the DPD actuator of the second DPD path may be the same DPD actuator as the DPD actuator of the first DPD path, and the inverse function coefficient may be applied differently. Predistortion on the second digital signal may be performed based on the second DPD path.

In this case, the second digital signal may be down sampled before the predistortion is performed. For example, a sampling rate of the second digital signal may be down sampled, by a down sampler (e.g., the down sampler 526 of FIG. 5) of the second DPD path, to have a second sampling rate decreased by an integer-factor from the first sampling rate. The integer-factor may be referred to as an adjustment magnification of a sampling rate. The down-sampled second digital signal may be predistorted by the DPD actuator.

In operation 850, the electronic device 500 may transmit a second output signal generated from the predistorted second digital signal, based on the power amplifier. For example, the second digital signal predistorted based on the second path may be up sampled by an up sampler (e.g., the up sampler 528 of FIG. 5) of the second path. The up sampling may have the same magnification as an adjustment magnification of the down sampling. For example, in a case that the down sampling is two-times down sampling, the up sampling may be two-times up sampling. Accordingly, a sampling rate of the second digital signal may be changed from the second sampling rate to the first sampling rate. The up-sampled second digital signal may be provided to the DAC. In this case, the first sampling rate may correspond to an operating rate of the DAC. The up-sampled second digital signal may be analog converted by the DAC. A second input signal analog-converted by the DAC from the second digital signal may be provided to the power amplifier. The power amplifier may generate the second output signal from the second input signal. The second output signal may be transmitted through the transmission antenna 570 after passing through the isolator 560 and the filter 565.

In embodiments, an electronic device may comprise memory comprising one or more storage media storing instructions. The electronic device may comprise a transmission antenna. The electronic device may comprise a power amplifier connected with the transmission antenna. The electronic device may comprise a digital predistortion (DPD) circuit connected with the power amplifier and including a first DPD path and a second DPD path. The electronic device may comprise at least one processor including processing circuitry. The instructions, when executed individually or collectively by the at least one processor, may cause the electronic device to, based on the first DPD path, perform predistortion with respect to a first digital signal having a first sampling rate. The instructions, when executed individually or collectively by the at least one processor, may cause the electronic device to, transmit, via the transmission antenna, a first output signal generated from the predistorted first digital signal based on the power amplifier. The instructions, when executed individually or collectively by the at least one processor, may cause the electronic device to, based on a correlation value between the first digital signal and the first output signal, provide, to the DPD circuit, a control signal for activating the second DPD path among the first DPD path and the second DPD path. The instructions, when executed individually or collectively by the at least one processor, may cause the electronic device to, perform predistortion with respect to a second digital signal subsequent to the first digital signal having a second sampling rate decreased by an integer-factor of the first sampling rate based on the second DPD path. The instructions, when executed individually or collectively by the at least one processor, may cause the electronic device to, transmit, via the transmission antenna, a second output signal generated from the predistorted second digital signal based on the power amplifier.

According to an embodiment, the first DPD path may provide the predistortion and delay compensation with respect to the first digital signal. The second DPD path may provide down sampling, the predistortion, and sampling with respect to the second digital signal.

According to an embodiment, the instructions, when executed individually or collectively by the at least one processor, may cause the electronic device to, based on the second DPD path, perform down sampling for changing the first sampling rate of the second digital signal to the second sampling rate. The instructions, when executed individually or collectively by the at least one processor, may cause the electronic device to, based on the second DPD path, perform up sampling for changing, to the first sampling rate, the second sampling rate of the second digital signal on which the predistortion is performed.

According to an embodiment, the instructions, when executed individually or collectively by the at least one processor, may cause the electronic device to, based on the first DPD path, perform delay compensation with respect to the predistorted first digital signal. The delay compensation may be identified based on a processing delay between the first DPD path and the second DPD path.

According to an embodiment, the first output signal may be generated from a first input signal analog-converted from the predistorted first digital signal based on the power amplifier. The second output signal may be generated from a second input signal analog-converted from the predistorted second digital signal based on the power amplifier.

According to an embodiment, the instructions, when executed individually or collectively by the at least one processor, may cause the electronic device to obtain a feedback signal digital-converted from the first output signal. The instructions, when executed individually or collectively by the at least one processor, may cause the electronic device to identify the correlation value of the first digital signal with respect to a difference between the first digital signal and the feedback signal.

According to an embodiment, the correlation value may comprise a maximum value among correlation values of the first digital signal with respect to the difference between the first digital signal corresponding to samples and the feedback signal. Each of the samples may have a delay equal or greater than a reference delay. The reference delay may indicate a maximum delay which the DPD circuit provides.

According to an embodiment, the instructions, when executed individually or collectively by the at least one processor, may cause the electronic device to, based on identifying a ratio between the correlation value equal or greater than a reference value and the reference correlation value, generate the control signal for activating the second DPD path. The reference correlation value may indicate the correlation value corresponding to a current sample.

According to an embodiment, the instructions, when executed individually or collectively by the at least one processor, may cause the electronic device to, based on identifying the ratio equal or greater than the reference value, identify, from a first look-up table (LUT) corresponding to the first sampling rate for the predistortion performed based on the first DPD path, a second LUT corresponding to the second sampling rate for the predistortion performed based on the second DPD path. The first LUT and the second LUT may be associated with an inverse function of the power amplifier.

According to an embodiment, the electronic device may include another transmission antenna. The electronic device may include another power amplifier connected with the another transmission antenna. The electronic device may further include another DPD circuit connected with the power amplifier and including a third DPD path and a fourth DPD path. The instructions, when executed individually or collectively by the at least one processor, may cause the electronic device to, based on the third DPD path, perform predistortion with respect to the first digital signal having the first sampling rate. The instructions, when executed individually or collectively by the at least one processor, may cause the electronic device to transmit, via the another transmission antenna, a third output signal generated, from the first digital signal on which the predistortion is performed based on the third DPD path, based on the another power amplifier. The instructions, when executed individually or collectively by the at least one processor, may cause the electronic device to, based on an another correlation value between the first digital signal and the third output signal, provide, to the another DPD circuit, a control signal for activating the fourth DPD path among the third DPD path and the fourth DPD path. The instructions, when executed individually or collectively by the at least one processor, may cause the electronic device to perform predistortion with respect to the second digital signal having a third sampling rate decreased by an integer-factor of the first sampling rate based on the fourth DPD path. The instructions, when executed individually or collectively by the at least one processor, may cause the electronic device to transmit, via the another transmission antenna, a fourth output signal generated, from the second digital signal on which the predistortion is performed based on the fourth DPD path, based on the power amplifier.

According to an embodiment, the electronic device may include a radio unit (RU). The instructions, when executed individually or collectively by the at least one processor, may cause the electronic device to obtain carrier configuration information from a distributed unit (DU) connected with the RU. The instructions, when executed individually or collectively by the at least one processor, may cause the electronic device to, based on the carrier configuration information, deactivate the activated second DPD path, and provide an another control signal for activating the deactivated first DPD path to the DPD circuit. The carrier configuration information may include bandwidth information of a transmission signal. The transmission signal may include the first output signal or the second output signal radiated from the transmission antenna.

According to an embodiment, the bandwidth information may include at least one of instantaneous bandwidth (IBW) or occupied bandwidth (OBW).

In embodiments, a method performed by an electronic device may comprise, based on a first digital predistortion (DPD) path of a DPD circuit included in the electronic device, performing predistortion with respect to a first digital signal having a first sampling rate. The method may comprise transmitting, a first output signal generated from the predistorted first digital signal based on the power amplifier. The method may comprise, based on a correlation value between the first digital signal and the first output signal, providing, to the DPD circuit, a control signal for activating a second DPD path among the first DPD path and the second DPD path of the DPD circuit, the correlation value equal or greater than a reference value. The method may comprise, performing predistortion with respect to a second digital signal subsequent to the first digital signal having a second sampling rate decreased by an integer-factor of the first sampling rate based on the second DPD path. The method may comprise, transmitting, a second output signal generated from the predistorted second digital signal based on the power amplifier.

In embodiments, a non-transitory computer-readable storage medium may store one or more programs including instructions that, when executed individually or collectively by at least one processor of an electronic device with a transmission antenna, a power amplifier connected to the transmission antenna, and a digital predistortion (DPD) circuit connected with the power amplifier and including a first DPD path and a second DPD path, cause the electronic device to, based on the first DPD path, perform predistortion with respect to a first digital signal having a first sampling rate. The non-transitory computer-readable storage medium may store one or more programs including instructions that, when executed individually or collectively by the at least one processor, cause the electronic device to transmit, via the transmission antenna, a first output signal generated from the predistorted first digital signal based on the power amplifier. The non-transitory computer-readable storage medium may store one or more programs including instructions that, when executed individually or collectively by the at least one processor, cause the electronic device to, based on a correlation value between the first digital signal and the first output signal, provide, to the DPD circuit, a control signal for activating the second DPD path among the first DPD path and the second DPD path. The non-transitory computer-readable storage medium may store one or more programs including instructions that, when executed individually or collectively by the at least one processor, cause the electronic device to, perform predistortion with respect to a second digital signal subsequent to the first digital signal having a second sampling rate decreased by an integer-factor of the first sampling rate based on the second DPD path. The non-transitory computer-readable storage medium may store one or more programs including instructions that, when executed individually or collectively by the at least one processor, cause the electronic device to transmit, via the transmission antenna, a second output signal generated from the predistorted second digital signal based on the power amplifier.

In embodiments, an electronic device may comprise a transmission antenna. The electronic device may comprise a power amplifier connected with the transmission antenna. The electronic device may comprise a digital predistortion (DPD) circuit connected with the power amplifier. The electronic device may comprise a The DPD circuit may include a switch for selecting a first DPD path or a second DPD path, a down sampler for decreasing a sampling rate of a digital signal and an up sampler for increasing the sampling rate, a DPD actuator generating a signal on which predistortion is performed from the digital signal for a linearity of the power amplifier, and a delay block adjusting a processing delay between the first DPD path and the second DPD path. The first DPD path may include the DPD actuator and the delay block. The second DPD path may include the DPD actuator, the up sampler, and the down sampler.

According to an embodiment, the switch may include a demultiplexer for selecting the first DPD path or the second DPD path for the digital signal provided from the at least one processor.

According to an embodiment, the electronic device may further include a coupler between the power amplifier and the transmission antenna. The coupler may provide an output signal of the power amplifier.

According to an embodiment, the electronic device may further include analog to digital converter (ADC) connected with the coupler. The ADC provides a feedback signal digital-converted from the output signal.

According to an embodiment, the electronic device may further include at least one radio frequency (RF) component between the coupler and the transmission antenna. The at least one RF component may include a filter.

According to an embodiment, the electronic device may further include digital to analog converter (DAC) between the DPD circuit and the power amplifier. The DAC may provide an input signal of the power amplifier analog-converted from the signal on which predistortion is performed via the DPD circuit.

According to an embodiment, the electronic device may include another transmission antenna. The electronic device may include another power amplifier connected to the another transmission antenna. The electronic device may further include another digital predistortion (DPD) circuit connected to the another power amplifier and including a third DPD path and a fourth DPD path.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

**Claims**

1. An electronic device comprising:

   memory comprising one or more storage media storing instructions;
   a transmission antenna;
   a power amplifier connected with the transmission antenna;
   a digital predistortion (DPD) circuit connected with the power amplifier and including a first DPD path and a second DPD path; and
   at least one processor including processing circuitry,
   wherein the instructions, when executed individually or collectively by the at least one processor, cause the electronic device to:

   based on the first DPD path, perform predistortion with respect to a first digital signal having a first sampling rate;
   transmit, via the transmission antenna, a first output signal generated from the predistorted first digital signal based on the power amplifier;
   based on a correlation value between the first digital signal and the first output signal, provide, to the DPD circuit, a control signal for activating the second DPD path among the first DPD path and the second DPD path;
   perform predistortion with respect to a second digital signal subsequent to the first digital signal having a second sampling rate decreased by an integer-factor of the first sampling rate based on the second DPD path; and
   transmit, via the transmission antenna, a second output signal generated from the predistorted second digital signal based on the power amplifier.

2. The electronic device of claim 1,

   wherein the first DPD path provides the predistortion and delay compensation with respect to the first digital signal, and
   wherein the second DPD path provides down sampling, the predistortion, and sampling with respect to the second digital signal.

3. The electronic device of claim 1,
   wherein the instructions, when executed individually or collectively by the at least one processor, cause the electronic device to:

   based on the second DPD path, perform down sampling for changing the first sampling rate of the second digital signal to the second sampling rate; and
   based on the second DPD path, perform up sampling for changing, to the first sampling rate, the second sampling rate of the second digital signal on which the predistortion is performed.

4. The electronic device of claim 1,
   wherein the instructions, when executed individually or collectively by the at least one processor, cause the electronic device to:

   based on the first DPD path, perform delay compensation with respect to the predistorted first digital signal, wherein the delay compensation is identified based on a processing delay between the first DPD path and the second DPD path.

5. The electronic device of claim 1,

wherein the first output signal is generated from a first input signal analog-converted from the predistorted first digital signal based on the power amplifier, and
wherein the second output signal is generated from a second input signal analog-converted from the predistorted second digital signal based on the power amplifier.

6. The electronic device of claim 1,
wherein the instructions, when executed individually or collectively by the at least one processor, cause the electronic device to:

obtain a feedback signal digital-converted from the first output signal; and
identify the correlation value of the first digital signal with respect to a difference between the first digital signal and the feedback signal.

7. The electronic device of claim 6,

wherein the correlation value comprises a maximum value among correlation values of the first digital signal with respect to the difference between the first digital signal corresponding to samples and the feedback signal,
wherein each of the samples has a delay equal or greater than a reference delay, and
wherein the reference delay indicates a maximum delay which the DPD circuit provides.

8. The electronic device of claim 6,
wherein the instructions, when executed individually or collectively by the at least one processor, cause the electronic device to:

based on identifying a ratio between the correlation value equal or greater than a reference value and the reference correlation value, generate the control signal for activating the second DPD path,
wherein the reference correlation value indicates the correlation value corresponding to a current sample.

9. The electronic device of claim 8,
wherein the instructions, when executed individually or collectively by the at least one processor, cause the electronic device to:

based on identifying the ratio equal or greater than the reference value, identify, from a first look-up table (LUT) corresponding to the first sampling rate for the predistortion performed based on the first DPD path, a second LUT corresponding to the second sampling rate for the predistortion performed based on the second DPD path,
wherein the first LUT and the second LUT is associated with an inverse function of the power amplifier.

10. The electronic device of claim 1,

wherein the electronic device further includes:

another transmission antenna;
another power amplifier connected with the another transmission antenna;
another DPD circuit connected with the power amplifier and including a third DPD path and a fourth DPD path,

wherein the instructions, when executed individually or collectively by the at least one processor, cause the electronic device to:

based on the third DPD path, perform predistortion with respect to the first digital signal having the first sampling rate;
transmit, via the another transmission antenna, a third output signal generated, from the first digital signal on which the predistortion is performed based on the third DPD path, based on the another power amplifier;
based on an another correlation value between the first digital signal and the third output signal, provide, to the another DPD circuit, a control signal for activating the fourth DPD path among the third DPD path and the fourth DPD path;

perform predistortion with respect to the second digital signal having a third sampling rate decreased by an integer-factor of the first sampling rate based on the fourth DPD path; and

transmit, via the another transmission antenna, a fourth output signal generated, from the second digital signal on which the predistortion is performed based on the fourth DPD path, based on the power amplifier.

11. The electronic device of claim 1,

wherein the electronic device further includes a radio unit (RU),

wherein the instructions, when executed individually or collectively by the at least one processor, cause the electronic device to:

obtain carrier configuration information from a distributed unit (DU) connected with the RU;

based on the carrier configuration information, deactivate the activated second DPD path, and provide an another control signal for activating the deactivated first DPD path to the DPD circuit,

wherein the carrier configuration information includes bandwidth information of a transmission signal,

wherein the transmission signal includes the first output signal or the second output signal radiated from the transmission antenna.

12. The electronic device of claim 11,

wherein the bandwidth information includes at least one of instantaneous bandwidth (IBW) or occupied bandwidth (OBW).

13. A method performed by an electronic device comprising:

based on a first digital predistortion (DPD) path of a DPD circuit included in the electronic device, performing predistortion with respect to a first digital signal having a first sampling rate;

transmitting, a first output signal generated from the predistorted first digital signal based on the power amplifier;

based on a correlation value between the first digital signal and the first output signal, providing, to the DPD circuit, a control signal for activating a second DPD path among the first DPD path and the second DPD path of the DPD circuit, the correlation value equal or greater than a reference value;

performing predistortion with respect to a second digital signal subsequent to the first digital signal having a second sampling rate decreased by an integer-factor of the first sampling rate based on the second DPD path; and

transmitting, a second output signal generated from the predistorted second digital signal based on the power amplifier.

14. The method of claim 13,

wherein the first DPD path provides the predistortion and delay compensation with respect to the first digital signal, and

wherein the second DPD path provides down sampling, the predistortion, and sampling with respect to the second digital signal.

15. An electronic device comprising:

a transmission antenna;

a power amplifier connected with the transmission antenna;

a digital predistortion (DPD) circuit connected with the power amplifier; and

at least one processor,

wherein the DPD circuit includes:

a switch for selecting a first DPD path or a second DPD path,

a down sampler for decreasing a sampling rate of a digital signal and an up sampler for increasing the sampling rate,

a DPD actuator generating a signal on which predistortion is performed from the digital signal for a linearity of the power amplifier, and

a delay block adjusting a processing delay between the first DPD path and the second DPD path,

wherein the first DPD path includes the DPD actuator and the delay block, and
wherein the second DPD path includes the DPD actuator, the up sampler, and the down sampler.

FIG. 1

110

210 215 220

DU — RU

FIG. 2

210

DU

310

TRANSCEIVER

320

MEMORY

330

PROCESSOR

FIG. 3A

220

RU

360

RF TRANSCEIVER

365

FRONTHAUL
TRANSCEIVER

370

MEMORY

380

PROCESSOR

FIG. 3B

FIG. 4A

FIG. 4B

FIG. 5

FIG. 6

FIG. 7A

FIG. 7B

PERFORM PREDISTORTION ON FIRST DIGITAL SIGNAL HAVING FIRST SAMPLING RATE — 810

TRANSMIT FIRST OUTPUT SIGNAL GENERATED FROM PREDISTORTED FIRST DIGITAL SIGNAL BASED ON POWER AMPLIFIER — 820

PROVIDE, TO DPD CIRCUIT, CONTROL SIGNAL FOR ACTIVATING SECOND DPD PATH — 830

PERFORM PREDISTORTION ON SECOND DIGITAL SIGNAL HAVING SECOND SAMPLING RATE — 840

TRANSMIT SECOND OUTPUT SIGNAL GENERATED FROM PREDISTORTED SECOND DIGITAL SIGNAL BASED ON POWER AMPLIFIER — 850

FIG. 8

# INTERNATIONAL SEARCH REPORT

| | International application No. |
|---|---|
| | **PCT/KR2024/006191** |

| | |
|---|---|
| **A.** | **CLASSIFICATION OF SUBJECT MATTER** |
| | **H04B 1/04**(2006.01)i; **H04B 1/62**(2006.01)i; **H03F 1/32**(2006.01)i |

According to International Patent Classification (IPC) or to both national classification and IPC

| | |
|---|---|
| **B.** | **FIELDS SEARCHED** |

Minimum documentation searched (classification system followed by classification symbols)

H04B 1/04(2006.01); H03F 1/32(2006.01); H04B 1/40(2006.01); H04B 1/525(2015.01); H04L 25/03(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: DPD(digital predistortion), 경로(path), 전력 증폭기(power amplification), 샘플링 레이트(sampling rate), 안테나(antenna)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| A | US 2014-0133602 A1 (TEXAS INSTRUMENTS INCORPORATED) 15 May 2014 (2014-05-15)<br>See paragraphs [0018] and [0050]-[0052]; and claims 23-24. | 1-15 |
| A | US 8982995 B1 (MICROELECTRONICS TECHNOLOGY INC.) 17 March 2015 (2015-03-17)<br>See column 1, line 59 - column 10, line 40; and figures 1-3. | 1-15 |
| A | KR 10-2021-0012235 A (SAMSUNG ELECTRONICS CO., LTD.) 03 February 2021 (2021-02-03)<br>See paragraphs [0010]-[0258]; and figures 1-18. | 1-15 |
| A | KR 10-2023-0029921 A (ANALOG DEVICES INTERNATIONAL UNLIMITED COMPANY) 03 March 2023 (2023-03-03)<br>See paragraphs [0074]-[0224]; and figures 1-10c. | 1-15 |
| A | US 2019-0222179 A1 (NEC CORPORATION) 18 July 2019 (2019-07-18)<br>See paragraphs [0140]-[0227]; and figures 1-7 and 14. | 1-15 |

| | |
|---|---|
| ☐ Further documents are listed in the continuation of Box C. | ☑ See patent family annex. |

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **06 September 2024** | **06 September 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

# EP 4 734 379 A1

| INTERNATIONAL SEARCH REPORT<br>Information on patent family members | | International application No.<br><br>**PCT/KR2024/006191** | |
|---|---|---|---|

| Patent document<br>cited in search report | Publication date<br>(day/month/year) | Patent family member(s) | Publication date<br>(day/month/year) |
|---|---|---|---|
| US 2014-0133602 A1 | 15 May 2014 | CN 102652397 A | 29 August 2012 |
| | | US 2011-0135034 A1 | 09 June 2011 |
| | | US 8670501 B2 | 11 March 2014 |
| | | US 9705539 B2 | 11 July 2017 |
| | | WO 2011-072137 A2 | 16 June 2011 |
| | | WO 2011-072137 A3 | 24 November 2011 |
| | | WO 2011-072137 A9 | 06 October 2011 |
| US 8982995 B1 | 17 March 2015 | CN 104618283 A | 13 May 2015 |
| | | CN 104618283 B | 11 October 2019 |
| | | TW 201521353 A | 01 June 2015 |
| | | TW I516019 B | 01 January 2016 |
| KR 10-2021-0012235 A | 03 February 2021 | CN 112311415 A | 02 February 2021 |
| | | CN 112311415 B | 25 July 2023 |
| | | EP 3771095 A1 | 27 January 2021 |
| | | EP 3771095 B1 | 27 September 2023 |
| | | EP 4280441 A2 | 22 November 2023 |
| | | EP 4280441 A3 | 21 February 2024 |
| | | US 11502760 B2 | 15 November 2022 |
| | | US 11943001 B2 | 26 March 2024 |
| | | US 2021-0028872 A1 | 28 January 2021 |
| | | US 2023-0082108 A1 | 16 March 2023 |
| | | US 2024-0235702 A1 | 11 July 2024 |
| | | WO 2021-015499 A1 | 28 January 2021 |
| KR 10-2023-0029921 A | 03 March 2023 | CN 116057843 A | 02 May 2023 |
| | | EP 4193468 A2 | 14 June 2023 |
| | | JP 2023-537021 A | 30 August 2023 |
| | | US 2023-0421199 A1 | 28 December 2023 |
| | | WO 2022-029253 A2 | 10 February 2022 |
| | | WO 2022-029253 A3 | 17 March 2022 |
| US 2019-0222179 A1 | 18 July 2019 | JP 2019-0125863 A | 25 July 2019 |
| | | JP 7024420 B2 | 24 February 2022 |
| | | US 10554183 B2 | 04 February 2020 |

Form PCT/ISA/210 (patent family annex) (July 2022)